# EUROPEAN PATENT APPLICATION

(11) **EP 4 451 324 A1**
(43) Date of publication of application: **23.10.2024**
(21) Application number: 22907054.5
(22) Date of filing: 28.10.2022
(51) Int. Cl.: H01L 23/02, H01L 23/28, H01L 21/56, H01L 27/146

(54) **SEMICONDUCTOR DEVICE, ELECTRONIC DEVICE AND METHOD FOR PRODUCING SEMICONDUCTOR DEVICE**

(30) Priority: 13.12.2021 JP 2021202008
(71) Applicant: Sony Semiconductor Solutions Corporation, Atsugi-shi, Kanagawa 243-0014 (JP)
(72) Inventor: HAMAGUCHI, Shingo, Atsugi-shi, Kanagawa 243-0014 (JP); SEKI, Ayaka, Kikuchi-gun, Kumamoto 869-1102 (JP)
(74) Representative: MFG Patentanwälte Meyer-Wildhagen Meggle-Freund Gerhard PartG mbB
(86) International application number: PCT/JP2022/040535
(87) International publication number: WO 2023/112521

(57) **Abstract**

To stabilize a manufacturing yield by suppressing occurrence of scratches and stains on a transparent member provided so as to cover a semiconductor element from a front surface side in a semiconductor device.

A semiconductor device includes a substrate, a semiconductor element that is provided on the substrate, a transparent member that is provided on the semiconductor element through a support part, and a sealing resin part that is formed around the semiconductor element and the transparent member on the substrate, and the sealing resin part has a protrusion part having an upper surface thereof perpendicular to the plate thickness direction of the substrate, the upper surface being positioned above a front surface of the transparent member in the plate thickness direction.

## Description

### [Technical Field]

The present disclosure relates to a semiconductor device, an electronic apparatus, and a manufacturing method of a semiconductor device.

### [Background Art]

As a semiconductor device including an imaging element such as a CMOS image sensor and a semiconductor element such as a light-emitting element such as a semiconductor laser, there has been a device including the following package structure in the past. That is, a package structure in which a transparent member such as a plate-like glass is provided so as to cover a semiconductor element mounted on a substrate from an upper side (front surface side) and a sealing resin part is provided around the semiconductor element and the transparent member on the substrate has been provided (see, for example, PTL 1).

In a manufacturing process of a semiconductor device, a semiconductor chip is generally picked up by a suction collet when the semiconductor chip is conveyed. In the case of the semiconductor chip having the package structure as described above, the semiconductor chip is subjected to suction by the collet on a side where the transparent member is provided to the semiconductor element.

### [Citation List]

### [Patent Literature]

[PTL 1]
Japanese Patent Laid-Open No. 2010-114382

### [Summary]

### [Technical Problem]

In the package structure described above, a front surface (upper surface) of the transparent member becomes the uppermost surface in the package structure. Therefore, when being picked up by the collet, the semiconductor chip is subjected to a suction action by the collet on the front surface of the transparent member.

When the semiconductor chip is subjected to the suction action of the flat collet on the front surface of the transparent member, there is a risk that the collet interferes with the transparent member to scratch the transparent member or stains of the collet adhere to the transparent member to contaminate the transparent member. Occurrence of scratches and contamination in the transparent member causes a reduction in manufacturing yield. Therefore, in order to allow the collet to exert the suction action on regions other than the transparent member, a countermeasure of using a dedicate collet according to the type of package structure or the like is conceivable, and such a countermeasure is not preferable from the viewpoint of cost and the like.

An object of the present technique is to provide a semiconductor device, an electronic apparatus, and a manufacturing method of a semiconductor device that can suppress the occurrence of scratches and stains on a transparent member provided so as to cover a semiconductor element from the front surface side and can stabilize the manufacturing yield.

### [Solution to Problem]

A semiconductor device according to the present technique includes a substrate, a semiconductor element that is provided on the substrate, a transparent member that is provided on the semiconductor element through a support part, and a sealing resin part that is formed around the semiconductor element and the transparent member on the substrate, and the sealing resin part has a protrusion part having an upper surface thereof perpendicular to a plate thickness direction of the substrate, the upper surface being positioned above a front surface of the transparent member in the plate thickness direction.

In another aspect of the semiconductor device according to the present technique, in the semiconductor device, a dimension between the front surface of the transparent member and the upper surface of the protrusion part is 10 to 200 µm in the plate thickness direction.

In still another aspect of the semiconductor device according to the present technique, in the semiconductor device, the transparent member has a rectangular plate-like outer shape with one plate surface as the front surface, the protrusion part is formed in a frame shape by four side parts along a rectangular outer shape of the transparent member in plan view, and a width of each side part of the protrusion part is 100 µm or more.

In yet another aspect of the semiconductor device according to the present technique, in the semiconductor device, the protrusion part has a transparent member covering part extending on the front surface of the transparent member so as to cover an edge part of the front surface of the transparent member.

In further aspect of the semiconductor device according to the present technique, in the semiconductor device, a sealing resin receiving part that is provided at an edge part on the front surface of the transparent member and is in contact with the protrusion part on an outer side surface is provided.

An electronic apparatus according to the present technique includes a semiconductor device including a substrate, a semiconductor element that is provided on the substrate, a transparent member that is provided on the semiconductor element through a support part, and a sealing resin part that is formed around the semiconductor element and the transparent member on the substrate, and the sealing resin part has a protrusion part having an upper surface thereof perpendicular to a plate thickness direction of the substrate, the upper surface being positioned above a front surface of the transparent member in the plate thickness direction.

A manufacturing method of a semiconductor device according to the present technique includes a step of mounting a semiconductor element on a substrate, a step of providing, on the semiconductor element through a support part, a transparent member with at least a peripheral edge part of a front surface covered with a protective material, and a step of forming a sealing resin part around the semiconductor element and the transparent member on the substrate by use of a mold.

In another aspect of the manufacturing method of a semiconductor device according to the present technique, in the manufacturing method of a semiconductor device, as the protective material, a film-like member that wholly covers the front surface of the transparent member or partially covers the front surface except the peripheral edge part of the front surface is used, and a step of removing the protective material is included after the step of forming the sealing resin part.

In still another aspect of the manufacturing method of a semiconductor device according to the present technique, in the manufacturing method of a semiconductor device, the transparent member has a rectangular plate-like outer shape with one plate surface as the front surface, and, as the protective material, a material having a substantially rectangular outer shape corresponding to the front surface of the transparent member in plan view, and having at least any one of recess parts formed on four side parts and R-shaped parts formed at four corner parts in the outer shape in plan view is used.

In yet another aspect of the manufacturing method of a semiconductor device according to the present technique, in the manufacturing method of a semiconductor device, as the protective material, a material having a base material formed by a predetermined material and an adhesive layer for pasting the base material to the transparent member is used.

In further aspect of the manufacturing method of a semiconductor device according to the present technique, in the manufacturing method of a semiconductor device, the transparent member has a rectangular plate-like outer shape with one plate surface as the front surface, as the protective material, a material having a substantially rectangular outer shape corresponding to the front surface of the transparent member in plan view, having recess parts formed on four side parts in the outer shape in plan view, and having a base material formed by a predetermined material and an adhesive layer for pasting the base material to the transparent member is used, and a recess amount of each of the recess parts with respect to a virtual straight line along a rectangular shape in the outer shape in plan view is 0.7 to 1.3 times a thickness of the adhesive layer.

In still further aspect of the manufacturing method of a semiconductor device according to the present technique, in the manufacturing method of a semiconductor device, the predetermined material for forming the base material includes PET, and the adhesive layer is formed by use of an acrylic resin adhesive.

In yet further aspect of the manufacturing method of a semiconductor device according to the present technique, in the manufacturing method of a semiconductor device, in the step of forming the sealing resin part, a resin material in a liquid state at normal temperature is used as a resin material for forming the sealing resin part.

### [Brief Description of Drawings]

[FIG. 1]

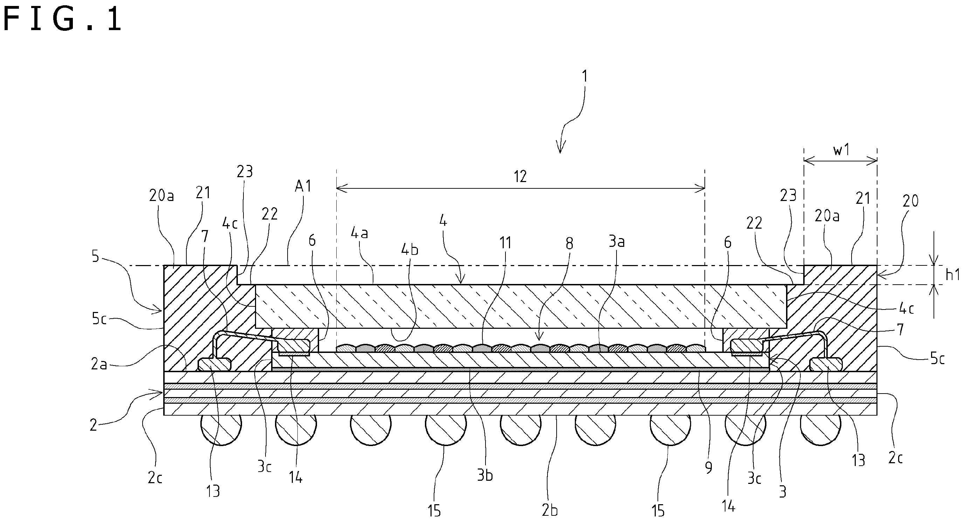

   FIG. 1 is a side cross-sectional view for depicting a configuration of an imaging device according to a first embodiment of the present technique.
[FIG. 2]

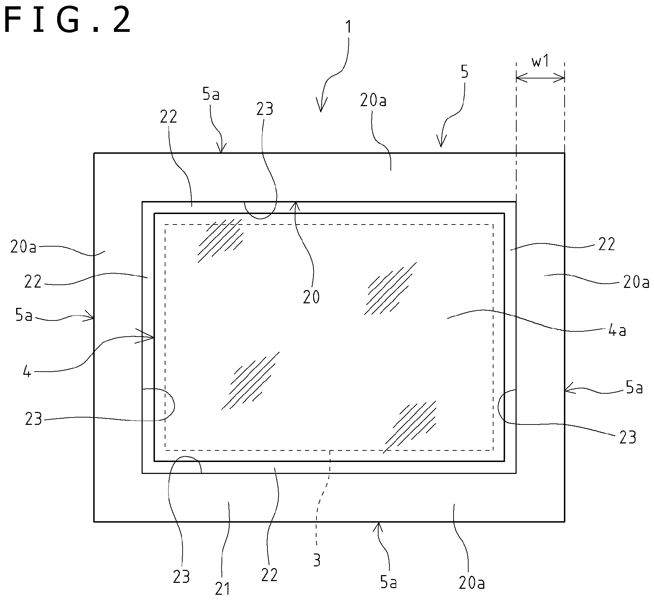

   FIG. 2 is a plan view for depicting a configuration of the imaging device according to the first embodiment of the present technique.
[FIG. 3]

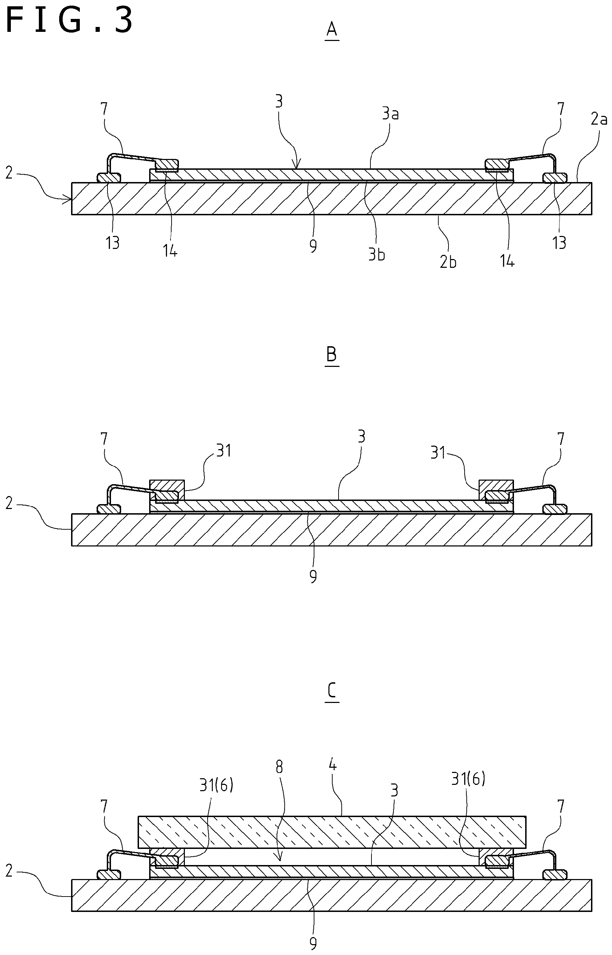

   FIG. 3 depicts explanatory diagrams for a manufacturing method of the imaging device according to the first embodiment of the present technique.
[FIG. 4]

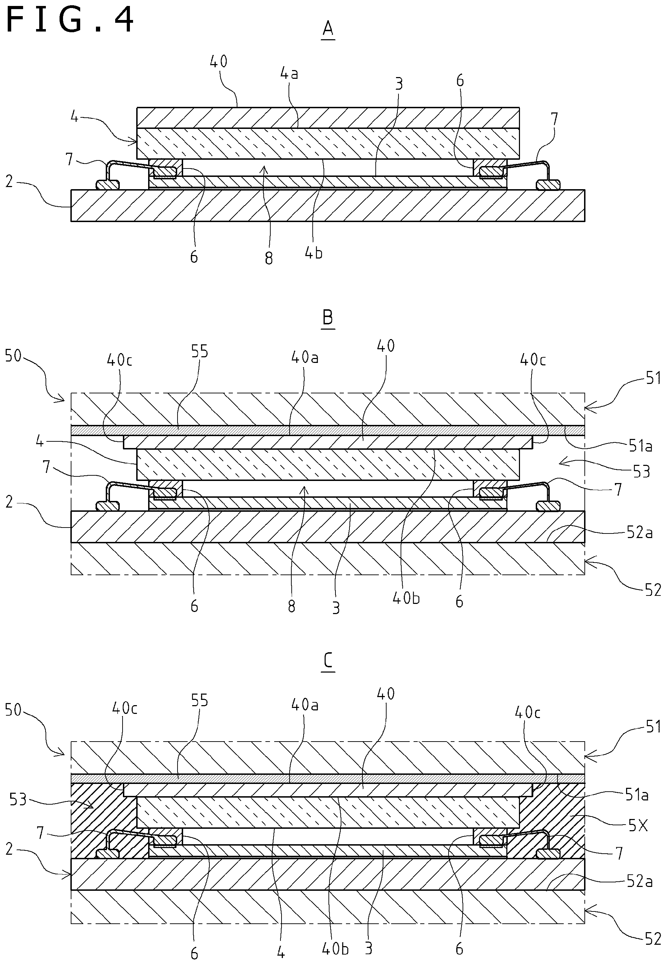

   FIG. 4 depicts explanatory diagrams for the manufacturing method of the imaging device according to the first embodiment of the present technique.
[FIG. 5]

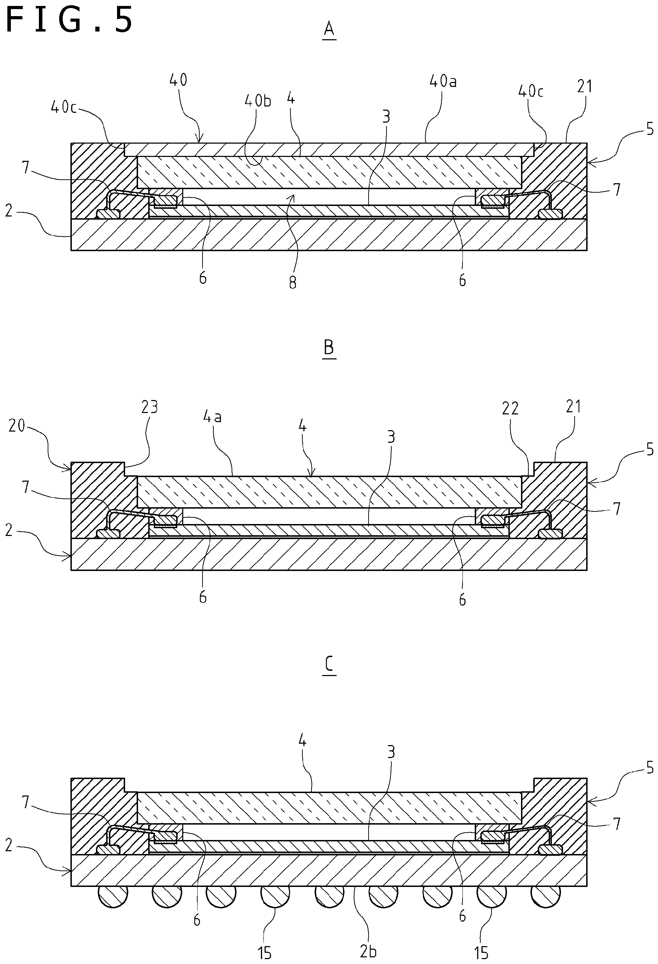

   FIG. 5 depicts explanatory diagrams for the manufacturing method of the imaging device according to the first embodiment of the present technique.
[FIG. 6]

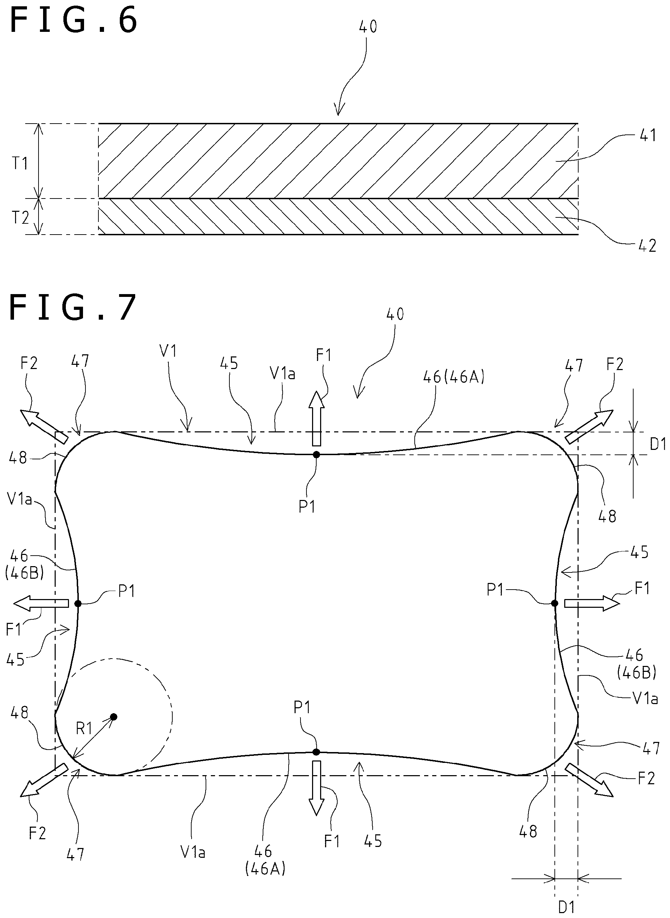

   FIG. 6 is a cross-sectional view for depicting a configuration of a protective sheet according to the first embodiment of the present technique.
[FIG. 7]
   FIG. 7 is a plan view for depicting a configuration of the protective sheet according to the first embodiment of the present technique.
[FIG. 8]

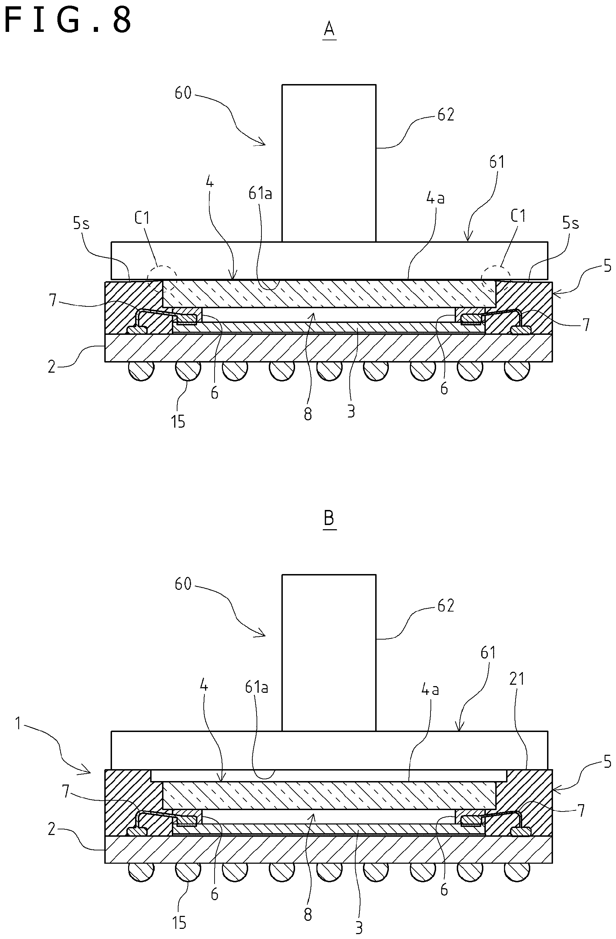

   FIG. 8 depicts explanatory diagrams for an effect of the imaging device according to the first embodiment of the present technique.
[FIG. 9]

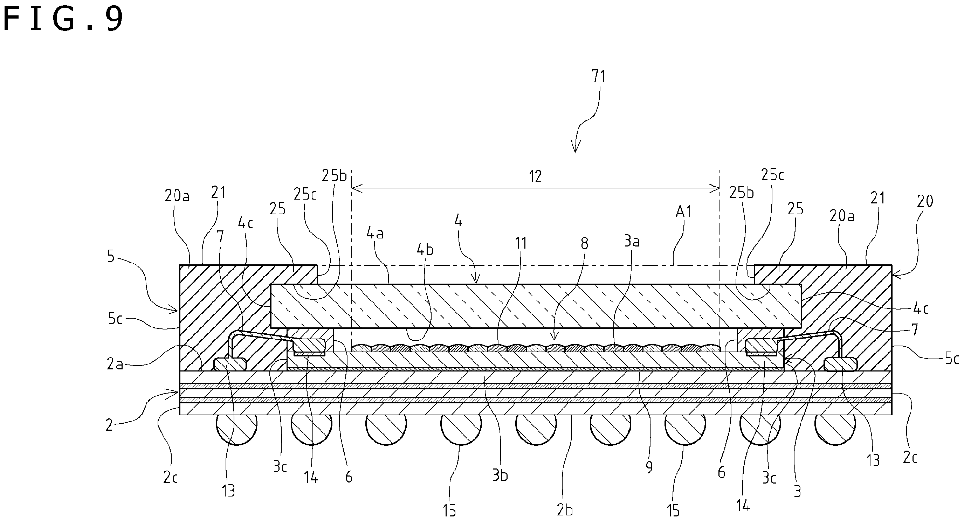

   FIG. 9 is a side cross-sectional view for depicting a configuration of an imaging device according to a second embodiment of the present technique.
[FIG. 10]

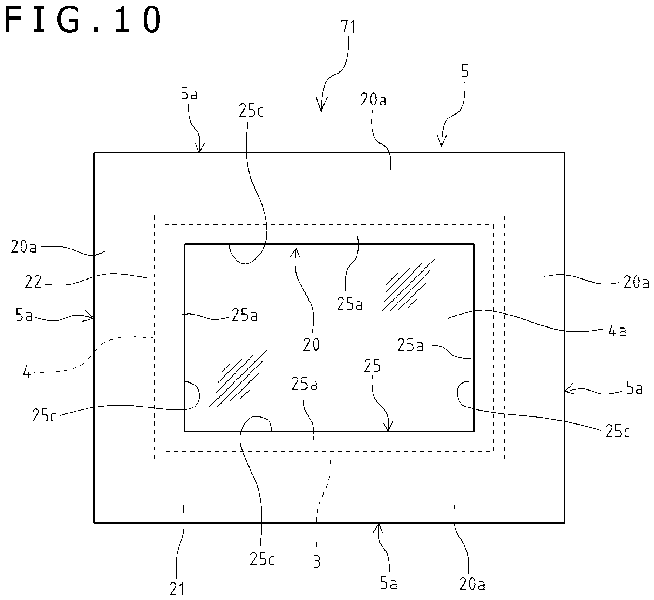

   FIG. 10 is a plan view for depicting a configuration of the imaging device according to the second embodiment of the present technique.
[FIG. 11]

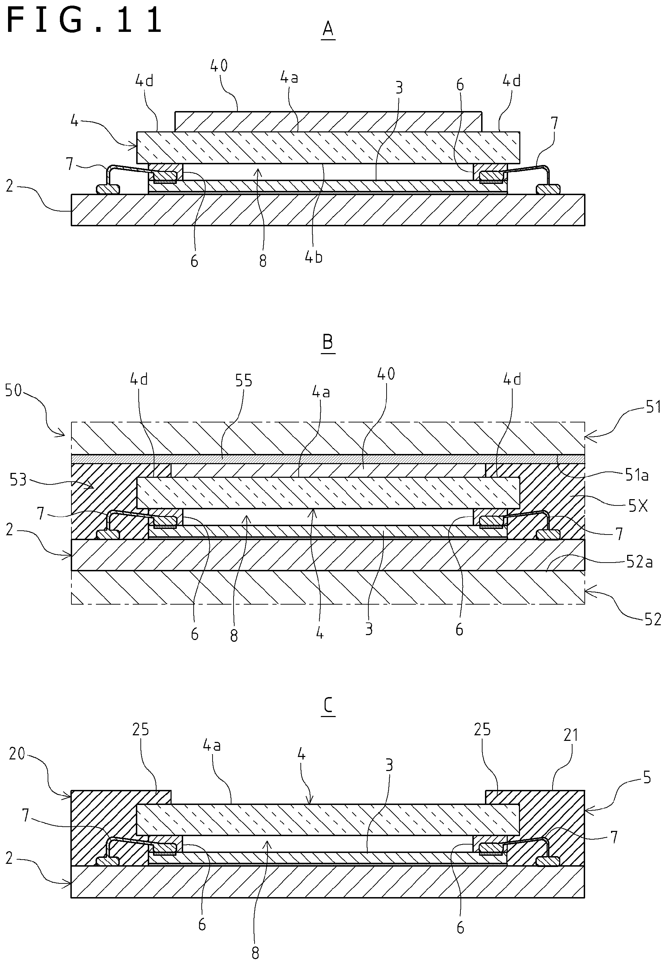

   FIG. 11 depicts explanatory diagrams for a manufacturing method of the imaging device according to the second embodiment of the present technique.
[FIG. 12]

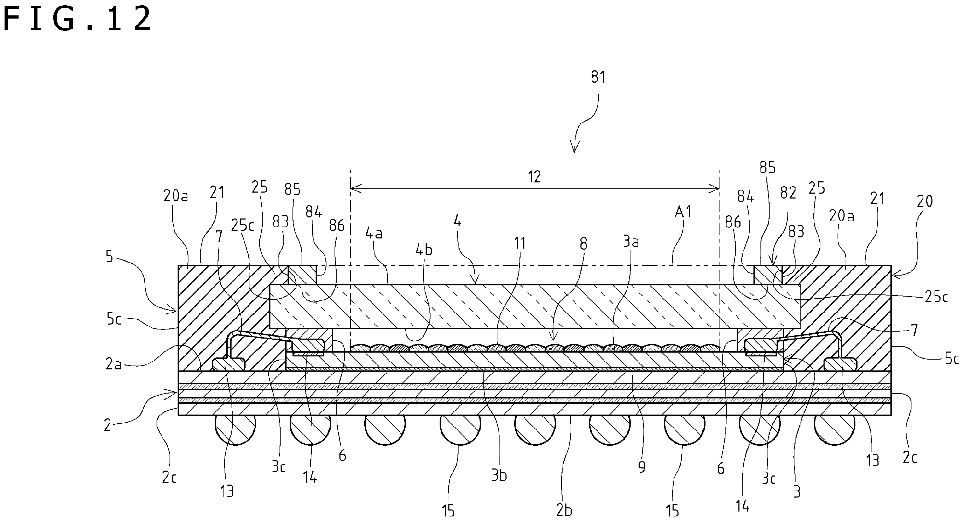

   FIG. 12 is a side cross-sectional view for depicting a configuration of an imaging device according to a third embodiment of the present technique.
[FIG. 13]

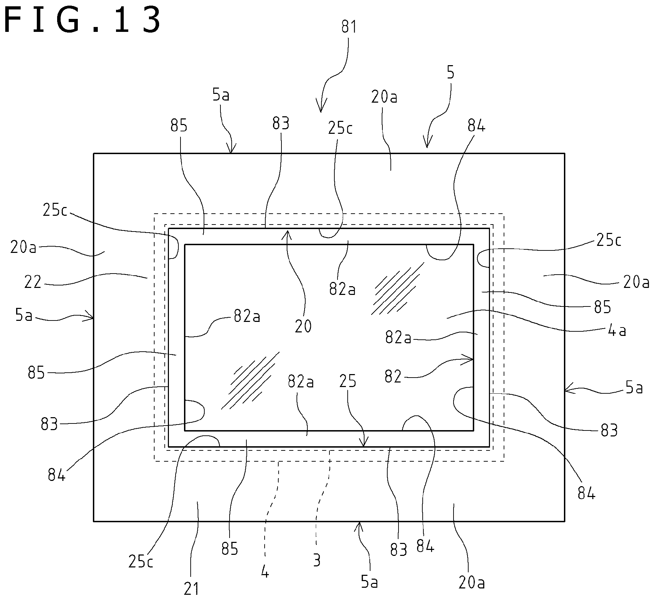

   FIG. 13 is a plan view for depicting a configuration of the imaging device according to the third embodiment of the present technique.
[FIG. 14]

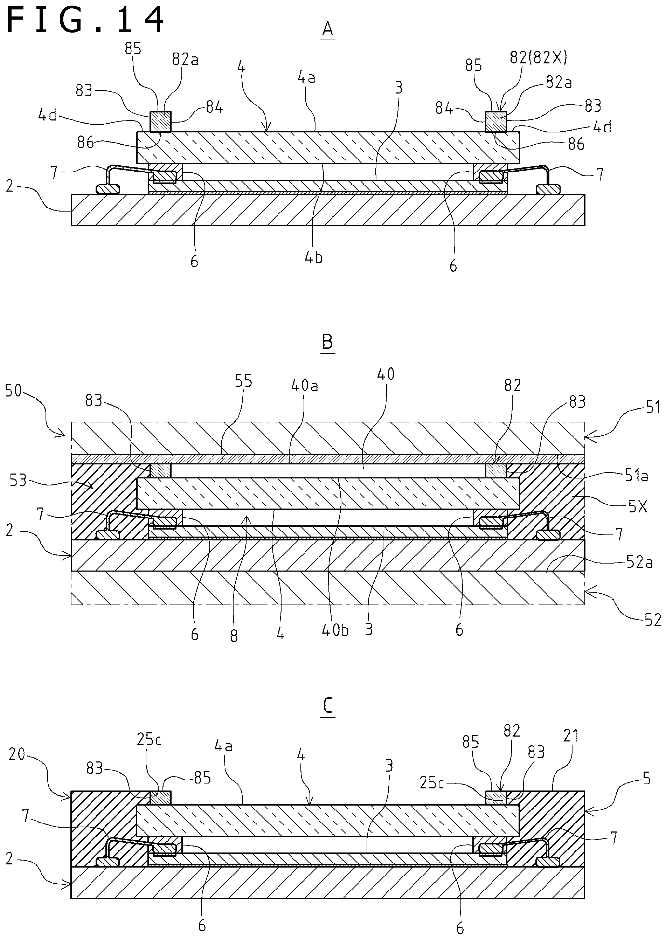

   FIG. 14 depicts explanatory diagrams for a manufacturing method of the imaging device according to the third embodiment of the present technique.
[FIG. 15]

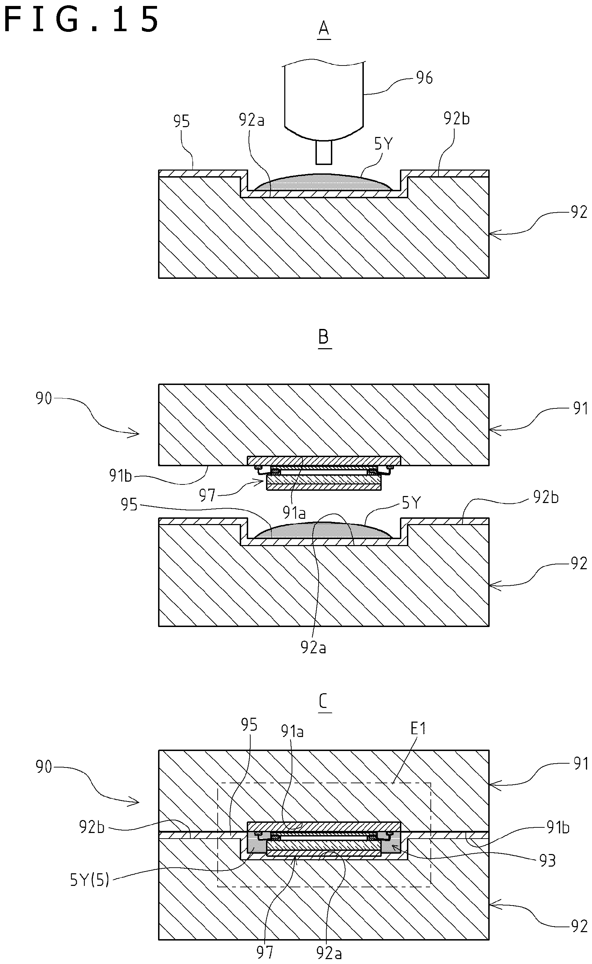

   FIG. 15 depicts explanatory diagrams for a manufacturing method of an imaging device according to a fourth embodiment of the present technique.
[FIG. 16]

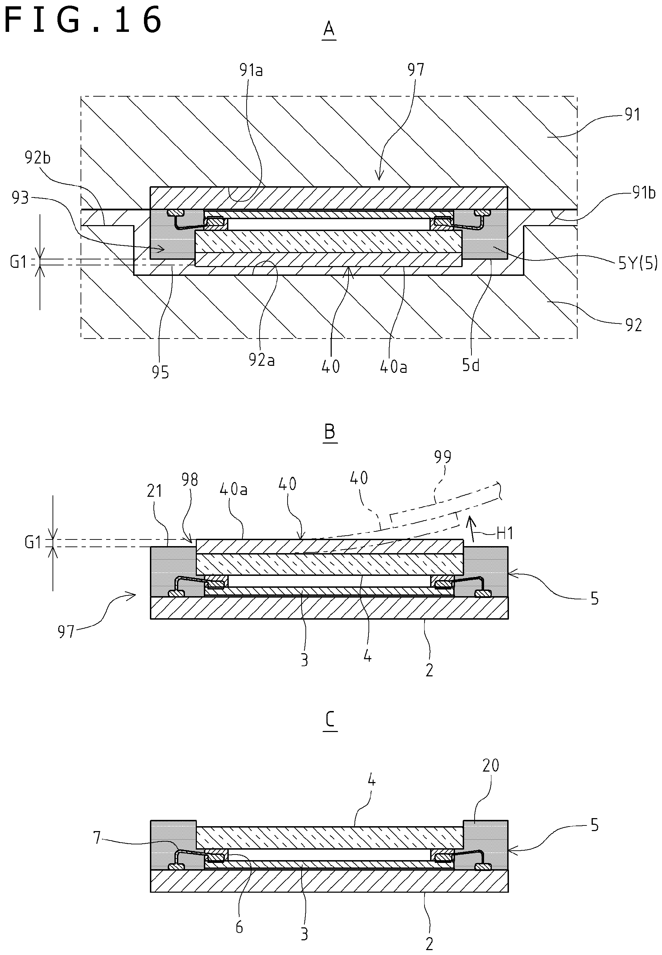

   FIG. 16 depicts explanatory diagrams for the manufacturing method of the imaging device according to the fourth embodiment of the present technique.
[FIG. 17]

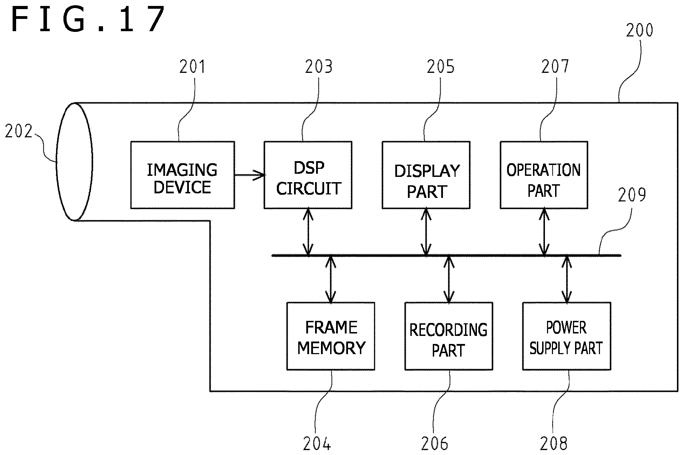

   FIG. 17 is a block diagram for depicting a configuration example of an electronic apparatus including the imaging device according to the embodiments of the present technique.

### [Description of Embodiments]

The present technique is intended to suppress the occurrence of scratches and stains on a transparent member in a manufacturing process of a semiconductor device and to reduce the cost by devising the shape of a sealing resin part formed around a semiconductor element and the transparent member on a substrate, a method of forming the sealing resin part, and the like.

Hereinafter, modes (hereinafter, referred to as "embodiments") for carrying out the present technique will be described with reference to the drawings. In the embodiments described below, an example of an imaging device (solid-state imaging device) including a solid-state imaging element that is an example of a semiconductor element will be described as a semiconductor device. It should be noted that the drawings are schematic, and the proportion and the like of dimensions of each part do not necessarily match the actual ones. In addition, it is obvious that parts that are different in relation and proportion of the dimensions from each other are included among the drawings. The embodiments will be described in the following order.
1. Configuration example of imaging device according to first embodiment
2. Manufacturing method of imaging device according to first embodiment
3. Configuration example of imaging device according to second embodiment
4. Manufacturing method of imaging device according to second embodiment
5. Configuration example of imaging device according to third embodiment
6. Manufacturing method of imaging device according to third embodiment
7. Manufacturing method of imaging device according to fourth embodiment
8. Configuration example of electronic apparatus

### <1. Configuration example of imaging device according to first embodiment>

A configuration example of an imaging device according to a first embodiment of the present technique will be described with reference to FIG. 1 and FIG. 2. It should be noted that a vertical direction in FIG. 1 is assumed to be the vertical direction in an imaging device 1.

As depicted in FIG. 1 and FIG. 2, the imaging device 1 is a kind of semiconductor device, and includes a substrate 2, an image sensor 3 as a solid-state imaging element provided on the substrate 2, a glass 4 as a transparent member, and a sealing resin part 5 formed at a peripheral part of the imaging device 1. In addition, the imaging device 1 includes a support part 6 that is a rib resin part supporting the glass 4 on the image sensor 3 by being interposed between the image sensor 3 and the glass 4, and a plurality of bonding wires 7 as connection members.

The imaging device 1 includes a hollow package structure in which the glass 4 is mounted on the image sensor 3 through the support part 6 and a cavity 8 is formed between the image sensor 3 and the glass 4. In the imaging device 1, the glass 4 is supported against the image sensor 3 by the support part 6 provided on a front surface 3a that is the surface on a light receiving side of the image sensor 3 so as to be opposed to the front surface 3a. The periphery between the image sensor 3 and the glass 4 is sealed by the support part 6, and the void-like cavity 8 is formed.

The substrate 2 is an organic substrate including an organic material such as plastic as a base material and is a circuit substrate in which a predetermined circuit pattern formed by use of a metal material is formed. However, the substrate 2 may be another kind of substrate such as a ceramic substrate formed by use of ceramics or the like as a material.

The substrate 2 has a rectangular plate-like outer shape and has a front surface 2a on which the image sensor 3 is mounted, a rear surface 2b that is a plate surface on the opposite side thereof, and four side surfaces 2c. The image sensor 3 is die-bonded to the front surface 2a side of the substrate 2. The image sensor 3 is bonded to the front surface 2a of the substrate 2 by a joint layer 9 including a die bond material such as an insulating or conductive adhesive.

The image sensor 3 is a semiconductor element including a semiconductor substrate including silicon (Si) as an example of a semiconductor. The image sensor 3 is a rectangular plate-like chip, the front surface 3a side that is the upper (one) plate surface is the light receiving surface side, and the opposite (the other) plate surface is a rear surface 3b. The image sensor 3 has four side surfaces 3c. A plurality of light receiving elements (photoelectric conversion elements) is formed on the front surface 3a side of the image sensor 3. The image sensor 3 is a CMOS (Complementary Metal Oxide Semiconductor) type image sensor. However, the image sensor 3 may be another imaging element such as a CCD (Charge Coupled Device) type image sensor.

The image sensor 3 has, as a light receiving part on the front surface 3a side, a pixel region 12 including a large number of pixels 11 formed in a predetermined array such as, for example, a Bayer array, and a region around the pixel region 12 is a peripheral region. A predetermined peripheral circuit is formed in the peripheral region. The pixels 11 each have a photodiode as a photoelectric conversion part having a photoelectric conversion function and a plurality of pixel transistors.

On the front surface 3a side of the image sensor 3, color filters and on-chip lenses are formed on the semiconductor substrate in such a manner as to correspond to the respective pixels 11 through an anti-reflection film including an oxide film or the like, a flattened film including an organic material, and the like. Light incident on the on-chip lens is received by the photodiode through the color filter, the flattened film, and the like. It should be noted that the configuration of the image sensor 3 according to the present technique is not particularly limited.

The glass 4 is an example of a transparent member serving as an optical window and is provided on the image sensor 3 through the support part 6. The glass 4 has a rectangular plate-like outer shape with one plate surface as a front surface 4a and has substantially the same outer dimension as the image sensor 3 in plan view. The glass 4 is provided on the front surface 3a side of the image sensor 3 so as to substantially match the outer shape of the image sensor 3 in plan view and to be separated at a predetermined interval in parallel with the image sensor 3. The glass 4 has a front surface 4a that is an upper surface, a rear surface 4b that is the other plate surface on the opposite side and is a lower surface facing the image sensor 3, and four side surfaces 4c. The glass 4 is supported against the image sensor 3 by the support part 6 in a fixed state.

The glass 4 transmits various types of light incident from the front surface 4a side through an optical system such as a lens positioned above the glass 4. The light transmitted through the glass 4 reaches the light receiving surface of the image sensor 3 through the cavity 8. The glass 4 has a function of protecting the light receiving surface side of the image sensor 3. It should be noted that, as a transparent member according to the present technique, for example, a plastic plate, a silicon plate that transmits only infrared light, or the like can be used instead of the glass 4.

In the present embodiment, the glass 4 has an outer shape slightly larger than the image sensor 3 in plan view. That is, the glass 4 has an outer dimension with a little larger size than the image sensor 3 in plan view and is provided so as to position its four rectangular edges outside four edges of the image sensor 3. However, the size relation between the glass 4 and the image sensor 3 is not particularly limited.

The support part 6 is interposed between the image sensor 3 and the glass 4 and is bonded in a state where they are separated from each other, so that the cavity 8 that is a sealed space is formed between the image sensor 3 and the glass 4. The support part 6 is provided in the peripheral region so as to surround the pixel region 12 on the front surface 3a of the image sensor 3. The lower side of the support part 6 is connected to the front surface 3a of the image sensor 3, and the upper side thereof is connected to the rear surface 4b of the glass 4. The support part 6 functions as a sealing part for hermetically sealing the periphery of the cavity 8, and blocks, together with the glass 4, the intrusion of moisture (water vapor), dust, or the like from the outside into the cavity 8.

The support part 6 is provided over the whole circumference along the outer shape of each of the image sensor 3 and the glass 4 in plan view and is formed with no ends so as to form a rectangular frame in plan view. The support part 6 is provided at a position within the range of the outer shape of the glass 4 so as to follow the outer edge of the glass 4 in plan view. The support part 6 is provided at a position slightly inside the side surfaces 4c of the glass 4. However, the support part 6 may be provided such that the outer surface thereof is substantially flush with the side surfaces 4c of the glass 4.

The support part 6 is formed including an insulating material. Specifically, the material forming the support part 6 is, for example, a photosensitive adhesive such as a UV (ultraviolet) curable resin that is an acrylic resin, a thermosetting resin such as an epoxy resin, or a mixture thereof. The support part 6 is formed on the front surface 3a of the image sensor 3 by coating with a dispenser, patterning using photolithography, or the like. It should be noted that the support part according to the present technique is not limited to those including resin, and may be provided by pasting, for example, a structure including an inorganic material such as ceramics such as glass, metal, or silicon to the image sensor 3 and the glass 4 with an adhesive or the like.

The bonding wire 7 is a conductive wire for electrically connecting the substrate 2 and the image sensor 3 to each other. The bonding wire 7 is, for example, a thin metal wire including Au (gold), Cu (copper), Al (aluminum), or the like. The bonding wire 7 electrically connects a lead terminal 13 formed on the front surface 2a of the substrate 2 to an electrode pad 14 formed on the front surface 3a of the image sensor 3 as a terminal for transmitting and receiving signals to/from the outside.

A plurality of lead terminals 13 is formed on the front surface 2a of the substrate 2 in a predetermined array at regions outside the mounting part of the image sensor 3 and receives connection on the one end sides of the bonding wires 7. A plurality of electrode pads 14 is formed on the front surface 3a of the image sensor 3 in a predetermined array at regions outside the support part 6 and receives connection on the other end sides of the bonding wires 7. The electrode pads 14 and connection parts of the bonding wires 7 to the electrode pads 14 are covered with the support part 6. However, the arrangement positions of the electrode pads 14 and the support part 6 are not particularly limited.

As the material of the lead terminals 13 and the electrode pads 14, for example, an aluminum material or the like is used. Specifically, the lead terminals 13 and the electrode pads 14 are formed by coating a layer part of, for example, copper (Cu), tungsten (W), titanium (Ti), or the like with a plating layer of nickel (Ni) and a plating layer of gold (Au). The lead terminals 13 and the electrode pads 14 are formed by appropriately using plating, sputtering, printing, or other film forming methods.

The plurality of lead terminals 13 of the substrate 2 is electrically connected to a plurality of terminal electrodes formed on the rear surface 2b side of the substrate 2 through a predetermined wiring part formed in the substrate 2. Each terminal electrode is provided with a solder ball 15. For example, the solder balls 15 are formed in two-dimensional lattice point-like arrangement so as to follow the rectangular outer shape of the image sensor 3 and configure BGA (ball grid array). The solder balls 15 serve as terminals for making an electrical connection to the circuit substrate on which the imaging device 1 is mounted in an electronic apparatus on which the imaging device 1 is mounted.

In the imaging device 1 having the above configuration, light transmitted through the glass 4 passes through the inside of the cavity 8 and is received and detected by a light receiving element configuring each pixel 11 arranged in the pixel region 12 of the image sensor 3.

The sealing resin part 5 is formed around the image sensor 3 and the glass 4 on the peripheral part of the substrate 2. The sealing resin part 5 is a resin part that covers the bonding wires 7 and the connection parts of the bonding wires 7 to the substrate 2. That is, the periphery of the bonding wires 7 that is outside the cavity 8 on the substrate 2 is covered and sealed with the sealing resin part 5.

The sealing resin part 5 covers and seals the whole circumference around the image sensor 3 and the glass 4 on the substrate 2. Specifically, the sealing resin part 5 entirely covers the peripheral part of the front surface 2a of the substrate 2 on which the lead terminals 13 are formed, the side surfaces 3c of the image sensor 3, the side surfaces on the outer side of the support part 6, and the peripheral part of the rear surface 4b and the side surfaces 4c of the glass 4, in a state where parts of the bonding wires 7 extending outward from the support part 6 are embedded.

The sealing resin part 5 is formed in a frame shape along the rectangular outer shape of the substrate 2 in plan view and has four side parts 5a along the respective sides of the rectangular outer shape of the substrate 2 as depicted in FIG. 2. In addition, as depicted in FIG. 1, the sealing resin part 5 has side surface parts 5c continuous with the side surfaces 2c of the substrate 2 in such a manner as to be flush with the side surfaces 2c of the substrate 2.

The sealing resin part 5 is formed by curing a resin material around the image sensor 3 on the substrate 2 and the glass 4 in a configuration in which the image sensor 3 is mounted on the substrate 2, these are connected to each other by the bonding wires 7, and the glass 4 is mounted on the image sensor 3 through the support part 6. The sealing resin part 5 is formed into a predetermined shape by injection molding using, for example, a molding mold. However, the sealing resin part 5 may be a part formed by a potting process using, for example, a dispenser. In this case, the resin material serving as the sealing resin part 5 is applied to a predetermined region while being discharged from the nozzle of the dispenser, and then cured to form the sealing resin part 5.

The material of the sealing resin part 5 is, for example, a thermosetting resin containing silicon oxide as a main component or a filler such as alumina. As the resin material for forming the sealing resin part 5, for example, a thermosetting resin such as a phenolic resin, a silicon-based resin, an acrylic resin, an epoxy resin, a urethane resin, a silicon resin, or a polyetheramide resin, a thermoplastic resin such as polyamide-imide, polypropylene, or liquid crystal polymer, a photosensitive resin such as a UV curable resin that is an acrylic resin, rubber, and other known resin materials are used singly or in combination. In addition, the sealing resin part 5 may be a part formed including a resin material in a liquid state at normal temperature by compression molding or the like. It should be noted that the sealing resin part 5 has an insulating property.

In the present embodiment, the sealing resin part 5 is formed including a material having a light shielding property. Specifically, as a material of the sealing resin part 5, a black resin material containing a black pigment such as carbon black or titanium black is used. Accordingly, the sealing resin part 5 becomes a black part, and the sealing resin part 5 can function as a light shielding part.

As described above, the sealing resin part 5 provided at the peripheral part on the substrate 2 in the imaging device 1 has a protrusion part 20. The protrusion part 20 is formed as a part of the sealing resin part 5 by, for example, injection molding, and an upper surface 21 is positioned above the front surface 4a of the glass 4 in the vertical direction that is the plate thickness direction of the substrate 2. That is, the protrusion part 20 is a part in the sealing resin part 5 protruding upward from the front surface 4a of the glass 4.

The upper surface 21 of the protrusion part 20 is a surface perpendicular to the vertical direction. The protrusion part 20 is positioned on a common horizontal virtual plane A1. The protrusion part 20 has a constant or substantially constant protrusion height h1 from the front surface 4a of the glass 4.

The protrusion part 20 is formed so as to surround the whole circumference of the glass 4 along the plan view outer shape of the sealing resin part 5. Thus, the protrusion part 20 has four side parts 20a along the rectangular outer shape of the glass 4 in plan view and is formed in a frame shape in plan view by these side parts 20a (see FIG. 2). The four side parts 20a are linear parts along the sides of the glass 4, and the width w1 is made constant or substantially constant as a whole. Each side part 20a of the protrusion part 20 serves as an upper surface layer part of each side part 5a in the sealing resin part 5.

The protrusion part 20 is formed at a position slightly outside the four side surfaces 4c of the glass 4. Thus, the protrusion part 20 has an inner peripheral-side upper surface part 22 that is continuous with the front surface 4a of the glass 4 in such a manner as to be flush therewith and an inner surface part 23 that is an opposite surface of each of the four side surface parts 5c in the sealing resin part 5. However, it is not necessary to form the inner peripheral-side upper surface part 22.

Regarding the dimension of the protrusion part 20, the protrusion height h1, which is the dimension between the front surface 4a of the glass 4 and the upper surface 21 of the protrusion part 20, in the vertical direction is, for example, 10 to 200 µm. It should be noted that the thickness of the glass 4 is approximately 400 µm to 500 µm, as an example.

In addition, regarding the dimension of the protrusion part 20, the width w1 of each side part 20a of the protrusion part 20 is, for example, 100 µm or more. Thus, the width w1 of the side part 20a is, for example, a value within the range of 100 to 150 µm, a value within the range of 100 to 200 µm, a value within the range of 100 to 250 µm, or a value within the range of 100 to 300 µm. It should be noted that, as the chip size of the imaging device 1, one side of the square has, for example, 6 to 10 mm.

### <2. Manufacturing method of imaging device according to first embodiment>

An example of a manufacturing method of the imaging device 1 according to the first embodiment of the present technique will be described with reference to FIG. 3 to FIG. 7.

In the manufacturing method of the imaging device 1, first, a step of preparing the substrate 2 is performed. The substrate 2 is obtained, for example, by dicing and singulating a substrate member in which a plurality of substrate parts serving as the substrate 2 in the imaging device 1 is two-dimensionally connected. The plurality of lead terminals 13 is formed on the front surface 2a of the substrate 2.

In addition, a step of preparing the image sensor 3 as an imaging element mounted on the substrate 2 is performed. On the front surface 3a of the image sensor 3, the plurality of electrode pads 14 is formed through plating or the like.

In addition, a step of preparing the glass 4 as a transparent member mounted on the image sensor 3 is performed. The glass 4 is obtained, for example, by cutting a glass plate having a predetermined shape into a rectangular shape by dicing.

Subsequently, an assembly step is performed. In the assembly step, as depicted in FIG. 3A, a step of mounting the image sensor 3 on the substrate 2 is first performed. That is, die bonding of the image sensor 3 to the substrate 2 is performed. In this step, as depicted in FIG. 3A, the image sensor 3 is bonded to a predetermined mounting region on the front surface 2a of the substrate 2 by a die bond material such as an insulating or conductive resin paste that serves as the joint layer 9.

Next, as depicted in FIG. 3A, a step of providing the bonding wires 7 for electrically connecting the substrate 2 and the image sensor 3 to each other is performed. Here, wire bonding is performed in which the lead terminals 13 of the substrate 2 and the electrode pads 14 of the image sensor 3 are electrically connected to each other by the bonding wires 7.

Next, a step of providing the glass 4 on the image sensor 3 through the support part 6 is performed. Specifically, first, as depicted in FIG. 3B, a rib resin 31, which is a resin material serving as the support part 6, is applied to a predetermined region on the front surface 3a of the image sensor 3 by a dispenser or the like in a rectangular frame shape along the outer shape of the image sensor 3 in plan view. However, the rib resin 31 may be formed by patterning through photolithography or the like.

Next, as depicted in FIG. 3C, a step of mounting the glass 4 is performed. The glass 4 is mounted on the image sensor 3 so as to close an opening on the upper side of the rib resin 31. Thereafter, a step of curing the rib resin 31 on the front surface 3a of the image sensor 3 is performed. In a case where the rib resin 31 has a thermosetting property, a heating step (cure) for curing the rib resin 31 is performed in a state where the glass 4 is mounted on the image sensor 3 through the rib resin 31. When the rib resin 31 is cured, the glass 4 is fixed on the image sensor 3 through the support part 6 formed by the rib resin 31, and the cavity 8 as a sealed space is formed.

Subsequently, as depicted in FIG. 4A, a step of pasting a protective sheet 40 as a protective material to the front surface 4a of the glass 4 is performed. The protective sheet 40 has substantially the same shape and dimensions as the front surface 4a of the glass 4 and is pasted so as to cover the whole front surface 4a of the glass 4.

As the protective sheet 40, for example, a sheet having adhesiveness and heat resistance such that the covering state of the front surface 4a for the glass 4 can be maintained in injection molding for forming the sealing resin part 5 is used. In addition, as the protective sheet 40, a sheet having a thickness equal to the dimension of the protrusion height h1 (see FIG. 1) of the protrusion part 20 in the sealing resin part 5 of the imaging device 1 or a thickness larger than the dimension of the protrusion height h1 is used. As described above, in the present embodiment, the protective sheet 40 that is a film-like member that wholly covers the front surface 4a of the glass 4 is used as a protective material.

An example of the structure of the protective sheet 40 will be described. As depicted in FIG. 6, the protective sheet 40 has a base material 41 formed by a predetermined material and an adhesive layer 42 including an adhesive material for pasting the base material 41 to the glass 4. That is, the material configuration of the protective sheet 40 is a two-layer structure including the base material 41 and the adhesive layer 42. Regarding the thickness of each layer of the protective sheet 40, the layer thickness T1 of the base material 41 is thicker than the layer thickness T2 of the adhesive layer 42. However, the size relation between the layer thicknesses of the base material 41 and the adhesive layer 42 is not limited.

A predetermined material for forming the base material 41 is, for example, an organic-based film material. Specifically, for example, PET (polyethylene terephthalate) is used as a material of the base material 41. As a material of the adhesive layer 42, a material that can adhere to the base material 41 and can easily clean, even in a case where a glue residue (residue of an adhesive) occurs on the glass 4 as an adherend, the residue with an organic solvent or the like is used. Specifically, for example, an acrylic resin adhesive is used as a material of the adhesive layer 42.

In the present embodiment, the base material 41 is assumed to be formed by PET, and the adhesive layer 42 is assumed to be formed by an acrylic resin adhesive. However, the layer structure of the protective sheet 40 and the material of each layer are not limited. For example, in a case where the material of the adhesive layer 42 is a thermosetting resin, a step of curing the adhesive layer 42 is performed to fix the protective sheet 40 to the front surface 4a of the glass 4. In addition, the protective sheet 40 may have a single layer or a laminated structure of three or more layers.

As described above, the steps including the step of providing the glass 4 on the image sensor 3 and the step of pasting the protective sheet 40 to the front surface 4a of the glass 4 are the step of providing, on the image sensor 3 through the support part 6, the glass 4 with the front surface 4a covered with the protective sheet 40.

It should be noted that a method of mounting, on the image sensor 3, the glass 4 with the protective sheet 40 pasted to the front surface 4a in advance may be used. In this case, in the step of preparing the glass 4, the glass 4 with the protective sheet 40 is prepared. For example, the glass 4 with the protective sheet 40 is obtained in such a manner that the protective sheet is wholly pasted to the front surface of a glass plate in a wafer state before being singulated into the glass 4 in a chip state and the glass plate is then singulated together with the protective sheet. Here, as the protective sheet to be pasted to the front surface of the glass plate in a wafer state, the two-layer structure of the base material 41 formed by PET and the adhesive layer 42 of an acrylic resin adhesive as described above, or, for example, a DAF material (DAF: die attach film) used for bonding a semiconductor chip to a substrate, or the like can be used.

In a case where the glass 4 with the protective sheet 40 is used, the step of providing, on the image sensor 3 through the support part 6, the glass 4 with the front surface 4a covered with the protective sheet 40 is as follows. That is, after the rib resin 31 is applied onto the front surface 3a of the image sensor 3 as depicted in FIG. 3B, the glass 4 with the protective sheet 40 is mounted as depicted in FIG. 4A, and a curing step for curing the rib resin 31 is performed. By using the glass 4 with the protective sheet 40, the step of pasting the protective sheet 40 to the glass 4 provided on the image sensor 3 is omitted.

As depicted in FIG. 4A, after the configuration in which the glass 4 with the front surface 4a covered with the protective sheet 40 is provided on the image sensor 3 is obtained, a step of forming the sealing resin part 5 around the image sensor 3 on the substrate 2 and the glass 4 is performed by use of a mold 50 for molding the molding resin part.

As depicted in FIG. 4B, the mold 50 has an upper mold 51 that is a first mold, and a lower mold 52 that is a second mold for forming a cavity 53 which is a molding space together with the upper mold 51. The upper mold 51 has a flat molding surface 51a for forming the upper side of the sealing resin part 5. The lower mold 52 has a flat support surface 52a, as a surface for supporting the substrate 2, facing the molding surface 51a of the upper mold 51 in a parallel manner.

The mold 50 is a transfer mold and has a pot (not depicted) in which a tablet that is a solid resin of a molding material is set, and a plunger (not depicted) driven in the pot. The space in the pot communicates with the cavity 53 through a gate or the like serving as a passage for the resin material.

The molding surface 51a of the upper mold 51 is wholly covered with a film 55 formed by an elastic or plastic material. The film 55 is what is generally called a release film, and is, for example, automatically supplied from a supply device attached to the mold 50 and comes into close contact with the molding surface 51a of the upper mold 51 by vacuum suction or the like. For example, the film 55 is peeled off from the molding surface of the upper mold 51 each time the mold 50 is opened and the molded article is taken out, and is supplied for each shot of injection molding. According to the film 55, a resin material 5X forming the sealing resin part 5 is prevented from adhering to the molding surface 51a of the upper mold 51. The thickness of the film 55 is, for example, approximately 200 µm.

A workpiece subjected to the formation of the sealing resin part 5 is set to such a mold 50. It should be noted that the workpiece has the configuration depicted in FIG. 4A. As depicted in FIG. 4B, the workpiece is set in a state where it is placed at a predetermined position on the support surface 52a of the lower mold 52 in a direction in which the protective sheet 40 side is the upper mold 51 side and the substrate 2 side is the lower mold 52 side.

After the workpiece is set to the mold 50, the mold 50 becomes a mold closed state (mold clamped state), so that the cavity 53 is formed. In the mold closed state of the mold 50, the workpiece becomes a clamped state in which it is vertically sandwiched between the lower mold 52 and the upper mold 51. In the mold closed state of the mold 50, the film 55 is pressed against the protective sheet 40 on the glass 4, and the protective sheet 40 comes into close contact with the film 55. That is, the protective sheet 40 is pressed against the molding surface 51a of the upper mold 51 from an upper surface 40a side through the film 55. Accordingly, the protective sheet 40 is compressed in the thickness direction according to the thickness thereof and slightly expanded in the surface direction.

As depicted in FIG. 4C, after the end of the mold closed step, the tablet in the pot is melted and pumped in a predetermined passage as the resin material 5X and injected and filled into the cavity 53. In the step of injection molding, a black resin material having a light shielding property is used as the resin material 5X by containing, for example, a black pigment such as carbon black or titanium black. However, the resin material 5X is not limited to the material having a light shielding property.

When the filling of the resin material 5X into the cavity 53 is completed, the resin material 5X is cured by performing a predetermined process such as heating or cooling the resin material 5X. Accordingly, a resin part serving as the sealing resin part 5 is formed. Thereafter, the clamp by the mold 50 is released, the mold 50 is opened, and the workpiece subjected to injection molding is taken out.

As depicted in FIG. 5A, in the workpiece taken out from the mold 50, the protective sheet 40 remains on the glass 4. Here, for example, the upper surface 40a of the protective sheet 40 is flush with the upper surface 21 of the sealing resin part 5 by the molding surface 51a of the upper mold 51 in a horizontal state. However, depending on the thickness, the material, and the like of the protective sheet 40, the thickness of the protective sheet 40 may become thicker than that in the clamped state due to the return of the protective sheet 40 from the compressed state caused by the release of the clamp by the mold 50, or the protective sheet 40 may be deformed from the wholly pasted state to the front surface 4a of the glass 4.

As depicted in FIG. 5B, after the step of forming the sealing resin part 5, a step of removing the protective sheet 40 is performed. In this step, the protective sheet 40 on the glass 4 is peeled off by being picked up, for example, by a suction collet or the like. In addition, in a case where the residue of the adhesive layer 42 is present on the front surface 4a of the glass 4 in a state where the protective sheet 40 is peeled off, the residue is cleaned by use of, for example, an organic solvent.

By removing the protective sheet 40, the front surface 4a of the glass 4 whose periphery is surrounded by the sealing resin part 5 is exposed. Then, in the sealing resin part 5, the part surrounding the periphery of the protective sheet 40 serves as the protrusion part 20. That is, the horizontal molding surface 51a is filled with the resin material 5X above the front surface 4a of the glass 4 by the thickness of the protective sheet 40, and the part above the front surface 4a of the glass 4 serves as the protrusion part 20 in the sealing resin part 5. Thus, the protrusion height h1 (see FIG. 1) of the protrusion part 20 has the same or substantially the same dimension as the thickness of the protective sheet 40.

In a state where the protective sheet 40 is removed, the glass 4 and the sealing resin part 5 form a recess part having the front surface 4a of the glass 4 and the inner peripheral-side upper surface part 22 as a bottom surface part and the four inner surface parts 23 as side surfaces. In the injection molding, the peripheral part of the lower surface 40b of the protective sheet 40 serves as a surface forming the inner peripheral-side upper surface part 22, and the side surfaces 40c of the protective sheet 40 serve as surfaces forming the inner surface parts 23.

Then, as depicted in FIG. 5C, a step of providing the plurality of solder balls 15 on the rear surface 2b side of the substrate 2 is performed. Here, a step of ball mounting and reflow is performed in which solder is arranged and fixed to each of the plurality of terminal electrodes arranged and formed in a lattice point shape on the rear surface 2b side of the substrate 2.

By the manufacturing process as described above, the imaging device 1 as depicted in FIG. 1 and FIG. 2 can be obtained. It should be noted that, in the step of injection molding, the workpiece set in the mold may be one singulated into a chip-like piece corresponding to the imaging device 1, or a plurality of package structures including the image sensor 3 and the glass 4 may be provided on an integrated substrate sheet formed in the assembled state of the substrates 2. In a case where the workpiece set in the mold has a configuration using a substrate sheet, a dicing step is performed in which the workpiece taken out from the mold after the step of injection molding is cut and singulated for each predetermined region corresponding to the imaging device 1.

In the manufacturing method of the imaging device 1 as described above, a sheet having the following configuration is used as the protective sheet 40 pasted to the glass 4. As depicted in FIG. 7, the protective sheet 40 has a substantially rectangular plan view outer shape corresponding to the front surface 4a of the glass 4 and has recess parts 46 formed on four side parts 45 in the outer shape in plan view, and R-shaped parts 48 formed at four corner parts 47.

The recess part 46 is a curved recess part with respect to a rectangular virtual outer shape V1 corresponding to the outer shape of the glass 4 in plan view. The recess part 46 is formed in the middle part excluding both ends in each side part 45 of the protective sheet 40. The recess part 46 is formed so as to form, for example, an arc shape.

The protective sheet 40 has a shape constricted by the recess parts 46 on four sides facing each other in the longitudinal direction (the lateral direction in FIG. 7) and the short-length direction (the vertical direction in FIG. 7). That is, in the regions where the recess parts 46 are formed, the width gradually narrows from both ends to the central part in each direction of the longitudinal direction and the short-length direction of the protective sheet 40. It should be noted that the protective sheet 40 has a symmetrical or substantially symmetrical shape in each direction of the longitudinal direction and the short-length direction.

The protective sheet 40 is formed such that a recess amount D1 of the recess part 46 with respect to a virtual straight line V1a that is each side of the virtual outer shape V1 has a predetermined dimension. The recess amount D1 is a distance between each virtual straight line V1a and a vertex P1 positioned in the center of the recess part 46 in each direction of the longitudinal direction and the short-length direction of the protective sheet 40.

The recess amount D1 of the recess part 46 can be determined on the basis of, for example, the layer thickness T2 (see FIG. 6) of the adhesive layer 42 of the protective sheet 40. Specifically, the recess amount D1 of the recess part 46 with respect to the virtual straight line V1a along the rectangular shape in the outer shape of the protective sheet 40 in plan view is set as a dimension 0.7 to 1.3 times the layer thickness T2 of the adhesive layer 42. However, the magnitude of the recess amount D1 of the recess part 46 is not limited to values within the numerical range described above.

In addition, the recess amounts D1 on the long side and the short side of the protective sheet 40 may be different from each other. Specifically, for example, the recess amount D1 of the recess part 46 (46B) on the short side of the protective sheet 40 may be set longer than the recess amount D1 of the recess part 46 (46A) on the long side. In addition, the shape of the recess part 46 is not limited to an arc shape, and is only required to be a shape in which the protective sheet 40 is constricted in the longitudinal direction and the short-length direction as a pair of recess parts 46 of the protective sheet 40 facing each other in the longitudinal direction or the short-length direction.

The R-shaped part 48 is a rounded shape part formed to have an arc-shaped curve with respect to the right-angled corner part in the virtual outer shape V1. The protective sheet 40 is formed such that a curvature radius R1 of the arc formed by the R-shaped part 48 becomes a predetermined value.

The curvature radius R1 of the R-shaped part 48 is set to a value of, for example, approximately 0.2 mm. However, the magnitude of the curvature radius R1 is not particularly limited. In addition, the curvature radiuses R1 of the four corner parts 47 in the protective sheet 40 may be different in magnitude for each corner part 47.

In the present embodiment, the protective sheet 40 has the recess parts 46 and the R-shaped parts 48, and the protective sheet 40 may be only required to have at least any one of the recess parts 46 and the R-shaped parts 48. In addition, the recess parts 46 may be formed only on a part of the side parts 45 among the four side parts 45 of the protective sheet 40, such as, for example, being formed only on a set of side parts 45 facing each other in the protective sheet 40. In addition, the R-shaped parts 48 may be formed only at a part of the corner parts 47 among the four corner parts 47 of the protective sheet 40.

According to the imaging device 1 and the manufacturing method thereof according to the present embodiment as described above, it is possible to suppress the occurrence of scratches and stains on the glass 4 provided so as to cover the image sensor 3 from the front surface 3a side and to stabilize the manufacturing yield. Since the imaging device 1 has the protrusion part 20 in the sealing resin part 5, the protrusion part 20 can be a part subjected to the suction action by the collet when being picked up by the collet, so that it is possible to suppress the occurrence of scratches and stains on the glass 4 by the collet.

For example, as depicted in FIG. 8A, in the configuration of a comparative example in which the protrusion part 20 is not formed in the sealing resin part 5, the front surface 4a of the glass 4 becomes the uppermost surface in the package structure. In the package of the comparative example, an upper surface 5s of the sealing resin part 5 becomes a surface having substantially the same height as the front surface 4a of the glass 4 or lower than the front surface 4a of the glass 4. In particular, in a case where the protective sheet 40 is not used in the injection molding as described above, the glass 4 slightly bites into the film 55, so that the upper surface 5s of the sealing resin part 5 becomes a surface lower than the front surface 4a of the glass 4.

Therefore, as depicted in FIG. 8A, the package of the comparative example is subjected to the suction action by a collet 60 on the front surface 4a of the glass 4 when being picked up by the collet 60. The collet 60 is what is generally called a flat collet and has a rectangular plate-like holding part 61 for sucking and holding an object to be picked up, and a columnar support part 62 for attaching the collet 60 to the main body side of the pickup device. The holding part 61 has a suction surface 61a along a plane and brings the suction surface 61a into contact with the suction object. An intake passage formed in communication from the support part 62 to the holding part 61 faces and opens in the suction surface 61a. On the suction surface 61a, the suction action by a suction device provided on the main body side of the device is obtained by the intake passage.

As depicted in FIG. 8A, since the package of the comparative example is subjected to the suction action of the flat collet 60 on the front surface 4a of the glass 4, the suction surface 61a of the collet 60 interferes with the glass 4, especially the corner parts on the front surface 4a side (see the parts indicated by the symbol C1), and there is a risk that the glass 4 is scratched or that the stains of the collet 60 adhere to the glass 4 to contaminate the glass 4. The occurrence of scratches and contamination in the glass 4 causes a decrease in the manufacturing yield.

Therefore, as depicted in FIG. 8B, according to the imaging device 1 of the embodiment, since the sealing resin part 5 has the protrusion part 20 with the upper surface 21 positioned above the front surface 4a of the glass 4, the upper surface 21 of the sealing resin part 5 becomes the uppermost surface in the imaging device 1. Therefore, when being picked up by the collet 60, the imaging device 1 is subjected to the suction action by the collet 60 by contact of the suction surface 61a with the upper surface 21 of the sealing resin part 5.

Thus, it is possible to prevent the suction surface 61a of the collet 60 from interfering with the glass 4. Accordingly, it is possible to suppress scratching of the glass 4 caused by interference of the collet 60 and contamination of the glass 4 by stains of the collet 60 adhering to the glass 4, and as a result, the manufacturing yield can be stabilized or improved.

In addition, according to the imaging device 1, a flat collet such as the collet 60 depicted in FIG. 8B can be used. Accordingly, it is not necessary to use a dedicated collet according to the size or the like of the glass 4 as a collet for picking up the imaging device 1, and an increase in cost can be avoided.

Regarding the dimension of the protrusion part 20 of the sealing resin part 5, the dimension of the protrusion height h1 (see FIG. 1) is preferably within the range of 10 to 200 µm for the following reasons. That is, if the protrusion height h1 of the protrusion part 20 is less than 10 µm, the height of the upper surface 21 of the sealing resin part 5 with respect to the front surface 4a of the glass 4 becomes insufficient, and it becomes difficult to prevent the collet 60 from interfering with the glass 4.

In addition, if the protrusion height h1 of the protrusion part 20 exceeds 200 µm, the shrinkage stress of the sealing resin part 5 increases, and the shrinkage stress may cause an adverse effect on other configurations configuring the imaging device 1. In addition, if the protrusion height h1 of the protrusion part 20 exceeds 200 µm, the amount of the resin material forming the sealing resin part 5 increases, and thus there is a problem of increasing the cost.

In addition, if the protrusion height h1 of the protrusion part 20 exceeds 200 µm, the protrusion part 20 existing around the glass 4 becomes high, and thus, the incident light to the glass 4 easily hits the protrusion part 20. In a case where the incident light hits the inner surface part 23 of the protrusion part 20, the reflected light from the inner surface part 23 enters the image sensor 3, and thus, there is a possibility that the flare is generated or deteriorated. In addition, if the protrusion part 20 becomes high, there is a possibility of causing a problem that the incident light to the image sensor 3 is blocked by the protrusion part 20.

In addition, regarding the dimension of the protrusion part 20 of the sealing resin part 5, the width w1 (see FIG. 1) of each side part 20a of the protrusion part 20 is preferably 100 µm or more for the following reasons. That is, by securing 100 µm or more for the width w1 of each side part 20a of the protrusion part 20, it is possible to secure a sufficient area for the upper surface 21 of the sealing resin part 5 with which the suction surface 61a of the collet 60 is brought into contact. Accordingly, the suction action by the collet 60 can be sufficiently obtained, and the suction of the imaging device 1 by the collet 60 can be facilitated, so that an excellent pickup property for the imaging device 1 can be obtained.

In addition, the manufacturing method of the imaging device according to the present embodiment includes the step of providing, on the upper side of the image sensor 3, the glass 4 with the front surface 4a covered with the protective sheet 40 in the step of injection molding for forming the sealing resin part 5. That is, the manufacturing method according to the present embodiment uses the protective sheet 40 covering the front surface 4a of the glass 4 to form the protrusion part 20 in the sealing resin part 5.

According to such a manufacturing method, by using the protective sheet 40, it is not necessary to form the mold in a complicated shape in order to form the protrusion part 20 in the sealing resin part 5, and the protrusion part 20 can be formed by using the existing mold having the flat molding surface 51a. Accordingly, the manufacturing cost of the imaging device 1 can be suppressed.

In addition, by using the protective sheet 40, it is possible to suppress the occurrence of stains and scratches on the front surface 4a of the glass 4 by injection molding for forming the sealing resin part 5. Accordingly, it is possible to stabilize the manufacturing yield. In addition, by using the protective sheet 40, the resin material can be dammed by the protective sheet 40 in injection molding, and it is possible to suppress the occurrence of burrs due to riding of the resin material on the front surface 4a of the glass 4. That is, it is possible to suppress the occurrence of burrs and bleeds caused by the infiltration of the resin material between the front surface 4a of the glass 4 and the film 55 on the upper mold 51 side due to variations in the flatness of the glass 4 or the like in a case where the protective sheet 40 is not used. In addition, by using the protective sheet 40 that is peeled off and removed in the manufacturing process, even in a case where burrs or the like occur on the protective sheet 40, it is possible to remove the burrs or the like together with the protective sheet 40 at the same time when the protective sheet 40 is peeled off. In addition, by using the protective sheet 40, damage to the glass 4 or the like caused by the clamping pressure of the mold 50 can be avoided. Thus, the manufacturing yield can be stabilized even by enabling suppression of the occurrence of burrs and the like and avoidance of damage to the glass 4 or the like as described above.

In addition, the manufacturing method of the imaging device according to the present embodiment includes the step of removing the protective sheet 40 after the step of injection molding for forming the sealing resin part 5 using the protective sheet 40 as a film-like member. According to such a manufacturing method, the front surface 4a of the glass 4 can be maintained in a clean state, and the performance of the imaging device 1 can be secured.

In addition, the manufacturing method of the imaging device according to the present embodiment uses the protective sheet 40 having the recess parts 46 formed on the four side parts 45 and the R-shaped parts 48 formed at the four corners. According to such a manufacturing method, for the protective sheet 40 that is compressed in the thickness direction by clamping the workpiece to the mold 50 and becomes a collapsed state, the shape of the mold 50 after deformation by clamping can be approximated to a rectangular shape corresponding to the shape of the glass 4 in plan view.

Specifically, as depicted in FIG. 7, regarding the planar deformation of the protective sheet 40 by clamping the workpiece to the mold 50, the four side parts 45 are deformed so as to swell outward (see the arrows F1), and the corner parts 47 are deformed so as to project outward at the four corners (see the arrows F2). In these deformations, for example, in a case where the protective sheet 40 has the virtual outer shape V1, a part of the protective sheet 40 is deformed to protrude outward with respect to the virtual outer shape V1.

Therefore, according to the protective sheet 40 having the shape in plan view as depicted in FIG. 7, for the deformation caused by the clamping of the mold 50, the deformation caused on the side parts 45 is offset by the recess parts 46, and the side parts 45 are approximated to the shape along the virtual straight line V1a. In addition, the deformation generated at the corner parts 47 is offset by the R-shaped parts 48, and the corner parts 47 are approximated to the shapes along the right-angled corner parts of the virtual outer shape V1. Thus, by providing the recess parts 46 and the R-shaped parts 48 in the protective sheet 40, the shape of the protective sheet 40 at the time of injection molding, that is, in the clamped state by the mold 50 can be approximated to a rectangular shape. Accordingly, the formation area of the sealing resin part 5 can easily be controlled.

In addition, the recess amount D1 of the recess part 46 is preferably within the range of 0.7 to 1.3 times the layer thickness T2 of the adhesive layer 42. Accordingly, the shape of the protective sheet 40 in the deformed state by clamping of the mold 50 can effectively be approximated to a rectangular shape (virtual outer shape V1). In addition, by allowing the curvature radius R1 of the R-shaped part 48 to be approximately 0.2 mm, the shape of the protective sheet 40 in the deformed state can effectively be approximated to a rectangular shape.

In addition, the manufacturing method of the imaging device according to the present embodiment uses a two-layer structure of the base material 41 and the adhesive layer 42 as the protective sheet 40. According to such a manufacturing method, the protective sheet 40 can have a simple and inexpensive configuration.

In particular, as a preferred configuration of the protective sheet 40, a configuration in which the material of the base material 41 is PET and the material of the adhesive layer 42 is an acrylic resin adhesive is employed. Accordingly, it is possible to obtain excellent adhesion of the adhesive layer 42 to the base material 41, and to easily and safely clean the adhesive layer 42 remaining on the front surface 4a of the glass 4 after peeling off the protective sheet 40 by using an organic solvent. That is, it is possible to obtain excellent adhesiveness and removability of the protective sheet 40 to the front surface 4a of the glass 4.

### <3. Configuration example of imaging device according to second embodiment>

A configuration example of an imaging device 71 according to a second embodiment of the present technique will be described with reference to FIG. 9 and FIG. 10. In each embodiment described below, the same reference signs are given to the common configurations as in the first embodiment, and description of the duplicate contents is appropriately omitted.

As depicted in FIG. 9 and FIG. 10, the imaging device 71 according to the present embodiment differs from the imaging device 1 according to the first embodiment in terms of the structure of the protrusion part 20 of the sealing resin part 5. That is, in the imaging device 71 according to the present embodiment, the protrusion part 20 has a glass covering part 25 as a transparent member covering part that extends on the front surface 4a of the glass 4 so as to cover an edge part of the front surface 4a of the glass 4.

The glass covering part 25 is a part of the protrusion part 20 that extends inward along the front surface 4a of the glass 4 while maintaining the height of the upper surface 21 from the main body part of the protrusion part 20. The dimension (thickness) of the glass covering part 25 in the vertical direction is constant or substantially constant as a whole.

The glass covering part 25 is formed over the whole circumference of the edge part of the front surface 4a of the glass 4 along the outer shape of the glass 4 in plan view. Thus, the glass covering part 25 has four side parts 25a along the outer shape of the glass 4 in plan view and is formed in a frame shape in plan view by these side parts 25a (see FIG. 10). The four side parts 25a are linear parts along the sides of the glass 4, and the width thereof is constant or substantially constant as a whole. The side parts 25a of the glass covering part 25 are inner peripheral parts of the side parts 20a of the protrusion part 20. The glass covering part 25 forms the inner peripheral side of the upper surface 21 of the sealing resin part 5 by the upper surface thereof and has a lower surface 25b that is a contact surface with the front surface 4a of the glass 4 and an end surface 25c on the inner peripheral side.

The glass covering part 25 is formed in a region outside the pixel region 12 so as not to overlap the pixel region 12 of the image sensor 3 in plan view. That is, the glass covering part 25 is formed such that the end surface 25c on the inner peripheral side is positioned outside the pixel region 12.

### <4. Manufacturing method of imaging device according to second embodiment>

An example of a manufacturing method of the imaging device 71 according to the second embodiment will be described with reference to FIG. 11.

In the manufacturing method of the imaging device 71, as in the case of the first embodiment, die bonding and wire bonding are performed (see FIG. 3A), and the step of providing, on the image sensor 3 through the support part 6, the glass 4 with the front surface 4a covered with the protective sheet 40 is performed (see FIG. 3B, FIG. 3C, and FIG. 4A).

In the present embodiment, as depicted in FIG. 11A, a sheet having an outer dimension a little smaller than that of the glass 4 is used as the protective sheet 40. That is, the protective sheet 40 partially covers the front surface 4a of the glass 4 except a peripheral edge part of the front surface 4a. A part of the front surface 4a of the glass 4 that is not covered with the protective sheet 40, that is, an exposed part 4d of a peripheral edge of the front surface 4a serves as a formation region of the glass covering part 25. It should be noted that the magnitude of the protective sheet 40 is set in consideration of an increase (spread) in the area of the protective sheet 40 due to compression by clamping of the mold 50.

Next, as depicted in FIG. 11B, as in the case of the first embodiment, the step of forming the sealing resin part 5 is performed by injection molding with use of the mold 50. Here, the resin material 5X enters between the film 55 on the upper mold 51 side and the exposed part 4d of the front surface 4a of the glass 4 around the protective sheet 40 to form the glass covering part 25.

After the step of forming the sealing resin part 5, a step of removing the protective sheet 40 is performed as depicted in FIG. 11C. Thereafter, the step of providing a plurality of solder balls 15 on the rear surface 2b side of the substrate 2 is performed (see FIG. 5C). By the manufacturing steps described above, as depicted in FIG. 9 and FIG. 10, the imaging device 71 including the sealing resin part 5 having the glass covering part 25 in the protrusion part 20 is obtained.

According to the imaging device 71 of the second embodiment, in addition to the effect obtained by the first embodiment, the following effect can be obtained. That is, with a configuration in which the protrusion part 20 of the sealing resin part 5 has the glass covering part 25 covering the glass 4, the sealing resin part 5 can have a function as a light shielding film for cutting unnecessary light.

Thus, in the configuration having the glass covering part 25, the sealing resin part 5 is preferably formed by a material having a light shielding property such as a black resin material containing a black pigment. By allowing the sealing resin part 5 to have a function as a light shielding film by the glass covering part 25, a light shielding function can be obtained in the glass 4 without using, for example, a glass with a relatively expensive light shielding film. Accordingly, the member cost can be suppressed.

### <5. Configuration example of imaging device according to third embodiment>

A configuration example of an imaging device 81 according to a third embodiment of the present technique will be described with reference to FIG. 12 and FIG. 13.

As depicted in FIG. 12 and FIG. 13, the imaging device 81 according to the present embodiment differs from the imaging device 71 according to the second embodiment in that a sealing resin receiving part 82 is provided on the front surface 4a of the glass 4 at a region inside the sealing resin part 5.

The sealing resin receiving part 82 is provided at the edge part on the front surface 4a of the glass 4 and is in contact with the protrusion part 20 at an outer surface 83 that is an outer side surface. The sealing resin receiving part 82 is formed over the whole circumference of the edge part of the front surface 4a of the glass 4 along the outer shape of the glass 4 in plan view. Thus, the sealing resin receiving part 82 has four side parts 82a along the outer shape of the glass 4 in plan view and is formed in a frame shape in plan view by these side parts 82a (see FIG. 13). The four side parts 82a are linear parts along the sides of the glass 4, and the width thereof is constant or substantially constant as a whole. In addition, the dimension (thickness) of the sealing resin receiving part 82 in the vertical direction is constant or substantially constant as a whole.

The sealing resin receiving part 82 has, for example, a rectangular transverse cross-sectional shape at each side part 82a. In a case where the transverse cross-sectional shape of each side part 82a is rectangular, the sealing resin receiving part 82 has the outer surface 83, an inner surface 84 that is a side surface on the opposite side (inner side) of the outer surface 83, an upper surface 85, and a lower surface 86 that a contact surface with the front surface 4a of the glass 4. The upper surface 85 of the sealing resin receiving part 82 is flush with the upper surface 21 of the sealing resin part 5.

The sealing resin receiving part 82 is formed in a region outside the pixel region 12 so as not to overlap the pixel region 12 of the image sensor 3 in plan view. That is, the sealing resin receiving part 82 is formed such that the inner surface 84 is positioned outside the pixel region 12.

In the examples depicted in FIG. 12 and FIG. 13, the sealing resin receiving part 82 is formed at a region slightly inside an edge of the front surface 4a of the glass 4. Therefore, the glass covering part 25 of the protrusion part 20 is formed at an edge end part of the front surface 4a of the glass 4. That is, the sealing resin receiving part 82 is surrounded by the glass covering part 25. The sealing resin receiving part 82 is in contact with the inner end surface 25c of the glass covering part 25 on the outer surface 83.

The material for forming the sealing resin receiving part 82 is not particularly limited, and is, for example, a photosensitive adhesive such as a UV (ultraviolet) curable resin that is an acrylic resin, a thermosetting resin such as an epoxy resin, or a mixture thereof. In addition, the material for forming the sealing resin receiving part 82 is preferably a material having a light shielding property such as a black resin material containing a black pigment such as carbon black. The sealing resin receiving part 82 is formed on the front surface 4a of the glass 4 by coating with a dispenser, patterning through photolithography, or the like.

In addition, the sealing resin receiving part 82 may be formed by pasting the protective sheet 40 used in the first embodiment and the like to the front surface 4a of the glass 4 as a frame shape. It should be noted that the sealing resin receiving part 82 is not limited to those including resin, and may be provided by pasting, for example, a structure including ceramics such as glass or an inorganic material such as metal or silicon to the glass 4 with an adhesive or the like.

### <6. Manufacturing method of imaging device according to third embodiment>

An example of a manufacturing method of the imaging device 81 according to the third embodiment will be described with reference to FIG. 14.

In the manufacturing method of the imaging device 81, as in the case of the first embodiment, die bonding and wire bonding are performed (see FIG. 3A), and the step of providing the glass 4 on the image sensor 3 through the support part 6 is performed (see FIG. 3B and FIG. 3C).

Thereafter, as depicted in FIG. 14A, a step of forming the sealing resin receiving part 82 as a protective material on the front surface 4a of the glass 4 is performed. In this step, a rib resin 82X, which is a resin material serving as the sealing resin receiving part 82, is applied to a predetermined region on the front surface 4a of the glass 4 by a dispenser or the like in a rectangular frame shape along the outer shape of the glass 4 in plan view. However, the rib resin 82X may be formed by patterning through photolithography, or the like.

Next, a step of curing the rib resin 82X on the front surface 4a of the glass 4 is performed. In a case where the rib resin 82X has thermosetting property, a heating step (cure) for curing the rib resin 82X is performed in a state where the rib resin 82X is applied to the front surface 4a of the glass 4. When the rib resin 82X is cured, the sealing resin receiving part 82 is formed on the glass 4 by the rib resin 82X.

The sealing resin receiving part 82 is formed at a region slightly inside the edge of the front surface 4a of the glass 4. Therefore, the exposed part 4d is present on the front surface 4a of the glass 4 outside the sealing resin receiving part 82, and the exposed part 4d serves as a formation region of the glass covering part 25. However, the sealing resin receiving part 82 may be provided at the edge of the front surface 4a of the glass 4 such that the exposed part 4d of the front surface 4a of the glass 4 is not present outside the sealing resin receiving part 82. In addition, a portion on the front surface 4a of the glass 4 inside the sealing resin receiving part 82 is exposed.

As the sealing resin receiving part 82, for example, a sheet having heat resistance such that the fixing state to the front surface 4a of the glass 4 can be maintained in injection molding for forming the sealing resin part 5 is used. In addition, as the sealing resin receiving part 82, a sheet having a thickness equal to the dimension of the protrusion height h1 (see FIG. 1) of the protrusion part 20 in the sealing resin part 5 of the imaging device 81 or a thickness larger than the dimension of the protrusion height h1 is used. As described above, in the present embodiment, the sealing resin receiving part 82 covering the peripheral edge part of the front surface 4a of the glass 4 is used as a protective material.

As described above, the steps including the step of providing the glass 4 on the image sensor 3 and the step of providing the sealing resin receiving part 82 on the front surface 4a of the glass 4 are the step of providing, on the image sensor 3 through the support part 6, the glass 4 with the peripheral edge part of the front surface 4a covered with the sealing resin receiving part 82.

It should be noted that a method of mounting, on the image sensor 3, the glass 4 with the sealing resin receiving part 82 provided on the front surface 4a in advance may be used. In this case, in the step of preparing the glass 4, the glass 4 with the sealing resin receiving part 82 is prepared. For example, the glass 4 with the sealing resin receiving part 82 is obtained in such a manner that, on the front surface of a glass plate in a wafer state before being singulated into chip-shaped glasses, the sealing resin receiving part 82 is provided for each region corresponding to each glass 4 and the glass plate is then singulated.

In a case where the glass 4 with the sealing resin receiving part 82 is used, the step of providing, on the image sensor 3 through the support part 6, the glass 4 with the peripheral edge part of the front surface 4a covered with the sealing resin receiving part 82 is as follows. That is, after the rib resin 31 is applied onto the front surface 3a of the image sensor 3 (see FIG. 3B), the glass 4 with the sealing resin receiving part 82 is mounted as depicted in FIG. 11A, and a curing step for curing the rib resin 31 is performed. By using the glass 4 with the sealing resin receiving part 82, the step of providing the sealing resin receiving part 82 on the glass 4 provided on the image sensor 3 is omitted.

Next, as depicted in FIG. 14B, as in the case of the first embodiment, the step of forming the sealing resin part 5 is performed by injection molding with use of the mold 50. Here, in a case where the sealing resin receiving part 82 has elasticity or plasticity, the sealing resin receiving part 82 is compressed by clamping the workpiece by use of the mold 50. In injection molding, the resin material 5X enters between the film 55 on the upper mold 51 side and the exposed part 4d of the front surface 4a of the glass 4 around the sealing resin receiving part 82 to form the glass covering part 25.

After the step of forming the sealing resin part 5 is performed, the workpiece taken out from the mold 50 has a configuration having the sealing resin part 5 including the protrusion part 20 and the sealing resin receiving part 82 as depicted in FIG. 14C. Thereafter, the step of providing a plurality of solder balls 15 on the rear surface 2b side of the substrate 2 is performed (see FIG. 5C). By the manufacturing steps described above, as depicted in FIG. 12 and FIG. 13, the imaging device 81 including the sealing resin part 5 having the glass covering part 25 in the protrusion part 20 and the sealing resin receiving part 82 is obtained. It should be noted that, in a case where the sealing resin receiving part 82 is provided at the edge of the front surface 4a of the glass 4, the glass covering part 25 is not formed in the protrusion part 20.

According to the imaging device 81 of the third embodiment and the manufacturing method thereof, in addition to the effects obtained by the first embodiment and the second embodiment, the following effect can be obtained. That is, by using the sealing resin receiving part 82 as a protective material provided on the front surface 4a of the glass 4 in order to form the protrusion part 20, the step of removing the protective material after forming the sealing resin part 5 can be omitted. Accordingly, the steps can be simplified.

In addition, with the configuration having the sealing resin receiving part 82, the sealing resin receiving part 82 can have a function as a light shielding film for cutting unnecessary light. Thus, the sealing resin receiving part 82 is preferably formed by a material having a light shielding property such as a black resin material containing a black pigment. By allowing the sealing resin receiving part 82 to have a function as a light shielding film, a light shielding function can be obtained in the glass 4 without using, for example, a glass with a relatively expensive light shielding film. Accordingly, the member cost can be suppressed.

### <7. Manufacturing method of imaging device according to fourth embodiment>

A fourth embodiment of the present technique will be described with reference to FIG. 15 and FIG. 16. The present embodiment is an embodiment for a manufacturing method of an imaging device and will be described by taking the imaging device 1 of the first embodiment as an example.

In the manufacturing method of the imaging device 1 of the present embodiment, in the step of forming the sealing resin part 5, a liquid resin 5Y that is a resin material in a liquid state at normal temperature is used as a resin material for forming the sealing resin part 5. As the liquid resin 5Y, for example, a resin such as a UV (ultraviolet) curable resin or a thermosetting resin that can be cured by post-treatment is used.

As depicted in FIG. 15B and FIG. 15C, in the manufacturing method according to the present embodiment, a mold 90 used for forming the sealing resin part 5 is what is generally called a compression molding mold and has an upper mold 91 that is a first mold, and a lower mold 92 that is a second mold forming a cavity 93 which is a molding space, together with the upper mold 91.

The upper mold 91 has a rectangular recess part 91a for holding a workpiece 97 on the molding surface side. The recess part 91a has a shape and a dimension substantially the same as those of the substrate 2 in terms of the outer shape in plan view and has a depth substantially the same as the thickness of the substrate 2. The workpiece 97 is held under suction by the upper mold 91 in a state where the substrate 2 is fitted into the recess part 91a. In the upper mold 91, an intake passage opened against the recess part 91a is provided, and the suction action by a suction device, which is not depicted, is obtained. The periphery of the recess part 91a is a flat mold alignment surface 91b with respect to the lower mold 92.

The lower mold 92 has a rectangular recess part 92a at a position opposite to the recess part 91a of the upper mold 91 on the molding surface side. The recess part 92a has a shape and a dimension substantially the same as those of the recess part 91a of the upper mold 91 in terms of the outer shape in plan view and has a depth substantially the same as the height of the sealing resin part 5. The periphery of the recess part 92a is a flat mold alignment surface 92b with respect to the upper mold 91.

The recess part 92a and the mold alignment surface 92b of the lower mold 92 are wholly covered with a buffer sheet 95 formed by an elastic or plastic material. The buffer sheet 95 functions as a buffer member and a release film, is automatically supplied from, for example, a supply device attached to the mold 90, and comes into close contact with the recess part 92a and the mold alignment surface 92b of the lower mold 92 by vacuum suction or the like. For example, the buffer sheet 95 is peeled off from the molding surface of the lower mold 92 each time the mold 90 is opened and the molded article is taken out and is supplied for each shot of injection molding. According to the buffer sheet 95, the liquid resin 5Y forming the sealing resin part 5 is prevented from adhering to the recess part 92a and the mold alignment surface 92b of the lower mold 92. The thickness of the buffer sheet 95 is, for example, approximately 200 µm.

The manufacturing method of the imaging device 1 according to the present embodiment is performed by the following procedure. First, as depicted in FIG. 15A, the liquid resin 5Y is supplied to the lower mold 92 in which the buffer sheet 95 is set to the recess part 92a and the mold alignment surface 92b. A prescribed amount of the liquid resin 5Y is applied into the recess part 92a of the lower mold 92 by a dispenser 96.

Next, as depicted in FIG. 15B, the upper mold 91 with the workpiece 97 held under suction in the recess part 91a is set to the lower mold 92. The workpiece 97 is set upside down in the mold 90 with the substrate 2 side as the upper side. It should be noted that the workpiece 97 has a configuration in which the glass 4 with the front surface 4a covered with the protective sheet 40 is provided on the image sensor 3 (see FIG. 4A).

Next, as depicted in FIG. 15C, the upper mold 91 is lowered or the like to come close to the lower mold 92, and mold clamping of the mold 90 is performed. When the mold 90 becomes a mold clamping state, the cavity 93 corresponding to the shape of the sealing resin part 5 is formed, and the liquid resin 5Y is filled into the cavity 93 while being compressed. In the mold clamping state of the mold 90, the buffer sheet 95 is sandwiched between the mold alignment surface 91b of the upper mold 91 and the mold alignment surface 92b of the lower mold 92, and the workpiece 97 is clamped between the upper and lower recess parts 91a and 92a.

Then, in the mold clamping state of the mold 90, as depicted in FIG. 16A, the buffer sheet 95 is pressed by the glass 4 through the protective sheet 40 and is partially compressed and deformed in the thickness direction while following the outer shape of the protective sheet 40. Accordingly, a level difference G1 in the vertical direction is generated between the upper surface 40a (the surface on the lower side in FIG. 16A) of the protective sheet 40 and a lower surface 5d of the liquid resin 5Y, which serves as the upper surface 21 in the sealing resin part 5. It should be noted that FIG. 16A is a partial enlarged view of E1 in FIG. 15C.

After the mold clamping of the mold 90 is performed, a step of curing the liquid resin 5Y by UV irradiation, heating, or the like is performed, and the sealing resin part 5 is formed. Thereafter, the mold 90 is opened, and the workpiece 97 subjected to injection molding is taken out.

As depicted in FIG. 16B, in the workpiece 97 taken out from the mold 90, the sealing resin part 5 is formed, and the protective sheet 40 remains on the glass 4. Here, the level difference G1 is present between the upper surface 40a of the protective sheet 40 and the upper surface 21 of the sealing resin part 5, and a level difference part 98 from the sealing resin part 5 is formed around the protective sheet 40.

Thereafter, a step of removing the protective sheet 40 is performed. In this step, for example, as depicted by the two-dot chain lines in FIG. 16B, a highly adhesive tape 99 is used to peel off the protective sheet 40 on the glass 4 (see an arrow H1). In addition, in a case where the residue of the adhesive layer 42 is present on the front surface 4a of the glass 4 in a state where the protective sheet 40 is peeled off, the residue is cleaned by use of, for example, an organic solvent.

When the protective sheet 40 is removed, as depicted in FIG. 16C, a configuration in which the sealing resin part 5 has the protrusion part 20 is obtained. Thereafter, the step of providing a plurality of solder balls 15 on the rear surface 2b side of the substrate 2 is performed (see FIG. 5C). By the manufacturing steps as described above, the imaging device 1 depicted in FIG. 1 and FIG. 2 can be obtained. It should be noted that the manufacturing method according to the present embodiment can also be applied as the manufacturing method of the imaging device 71 of the second embodiment and the imaging device 81 of the third embodiment.

According to the manufacturing method of the imaging device of the fourth embodiment, since a resin material in a liquid state at normal temperature can be used as a material of the sealing resin part 5, it is possible to use a resin material having a physical property that is difficult to obtain with a solid resin such as a tablet used in, for example, injection molding. Specifically, as a material of the sealing resin part 5, it is possible to use a resin having physical properties such as low elasticity, low Tg (Tg: glass transition temperature), and transparency.

In addition, according to the manufacturing method of the imaging device of the fourth embodiment, the level difference G1 can be formed between the upper surface 40a of the protective sheet 40 and the upper surface 21 of the sealing resin part 5. Accordingly, since the protective sheet 40 can easily be peeled off, an excellent peeling property of the protective sheet 40 can be obtained, and the step of removing the protective sheet 40 can easily be performed.

### <8. Configuration example of electronic apparatus>

An example of application of the imaging device according to the above-described embodiments to an electronic apparatus will be described with reference to FIG. 17.

The imaging device (solid-state imaging device) according to the present technique can be applied to an electronic apparatus in general that uses a solid-state imaging element for an image capturing part (photoelectric conversion part), such as a camera device, such as a digital still camera or a video camera, a portable terminal device having an imaging function, or a copying machine that uses a solid-state imaging element for an image reading part. The imaging device may be of a configuration formed as a single chip or may be of a module-like configuration having an imaging function in which an imaging part and a signal processing part or an optical system are packaged together.

As depicted in FIG. 17, a camera device 200 as an electronic apparatus includes an optical part 202, an imaging device 201, a DSP (Digital Signal Processor) circuit 203 that is a camera signal processing circuit, a frame memory 204, a display part 205, a recording part 206, an operation part 207, and a power supply part 208. The DSP circuit 203, the frame memory 204, the display part 205, the recording part 206, the operation part 207, and the power supply part 208 are appropriately connected to each other through a connection line 209 such as a bus line. The imaging device 201 is the imaging device 1 according to, for example, the first embodiment described above.

The optical part 202 includes a plurality of lenses, takes in incident light (image light) from an object, and forms an image on the imaging surface of the imaging device 201. The imaging device 201 converts the light quantity of the incident light formed on the imaging surface into an electric signal in pixel units by the optical part 202 and outputs it as a pixel signal.

The display part 205 includes, for example, a panel type display device such as a liquid crystal panel or an organic EL (Electro Luminescence) panel and displays a moving or still image captured by the imaging device 201. The recording part 206 records the moving or still image captured by the imaging device 201 on a recording medium such as a hard disk or a semiconductor memory.

The operation part 207 issues operation commands on various functions of the camera device 200 under the operation by the user. The power supply part 208 appropriately supplies various power sources as operating power sources for the DSP circuit 203, the frame memory 204, the display part 205, the recording part 206, and the operation part 207 to these supply targets.

According to the camera device 200 described above, regarding the imaging device 201, it is possible to suppress the occurrence of scratches and stains on the glass 4 provided so as to cover the image sensor 3 from the front surface 3a side, and to stabilize the manufacturing yield.

The description of the embodiments described above is an example of the present technique, and the present technique is not limited to the embodiments described above. Therefore, it is obvious that various changes can be made depending on the design and the like even in cases other than the embodiments described above, as long as the technical concept according to the present disclosure is not deviated. In addition, the effects described in the present disclosure are only illustrative and not limited, and there may be other effects. In addition, the configurations of each embodiment described above can appropriately be used in combination.

Note that the present technique can take the following configurations.
(1) A semiconductor device including:
   a substrate;
   a semiconductor element that is provided on the substrate;
   a transparent member that is provided on the semiconductor element through a support part; and
   a sealing resin part that is formed around the semiconductor element and the transparent member on the substrate,
   in which the sealing resin part has a protrusion part having an upper surface thereof perpendicular to a plate thickness direction of the substrate, the upper surface being positioned above a front surface of the transparent member in the plate thickness direction.
(2) The semiconductor device according to (1) above,
   in which a dimension between the front surface of the transparent member and the upper surface of the protrusion part is 10 to 200 µm in the plate thickness direction.
(3) The semiconductor device according to (1) above or (2) above,
   in which the transparent member has a rectangular plate-like outer shape with one plate surface as the front surface,
   the protrusion part is formed in a frame shape by four side parts along a rectangular outer shape of the transparent member in plan view, and
   a width of each side part of the protrusion part is 100 µm or more.
(4) The semiconductor device according to any one of (1) to (3) above,
   in which the protrusion part has a transparent member covering part extending on the front surface of the transparent member so as to cover an edge part of the front surface of the transparent member.
(5) The semiconductor device according to any one of (1) to (4) above,
   in which a sealing resin receiving part that is provided at an edge part on the front surface of the transparent member and is in contact with the protrusion part on an outer side surface is provided.
(6) An electronic apparatus including:
   a semiconductor device including
      a substrate,
      a semiconductor element that is provided on the substrate,
      a transparent member that is provided on the semiconductor element through a support part, and
      a sealing resin part that is formed around the semiconductor element and the transparent member on the substrate,
   in which the sealing resin part has a protrusion part having an upper surface thereof perpendicular to a plate thickness direction of the substrate, the upper surface being positioned above a front surface of the transparent member in the plate thickness direction.
(7) A manufacturing method of a semiconductor device, the method including:
   a step of mounting a semiconductor element on a substrate;
   a step of providing, on the semiconductor element through a support part, a transparent member with at least a peripheral edge part of a front surface covered with a protective material; and
   a step of forming a sealing resin part around the semiconductor element and the transparent member on the substrate by use of a mold.
(8) The manufacturing method of a semiconductor device according to (7) above,
   in which, as the protective material, a film-like member that wholly covers the front surface of the transparent member or partially covers the front surface except the peripheral edge part of the front surface is used, and
   a step of removing the protective material is included after the step of forming the sealing resin part.
(9) The manufacturing method of a semiconductor device according to (8) above,
   in which the transparent member has a rectangular plate-like outer shape with one plate surface as the front surface, and,
   as the protective material, a material having a substantially rectangular outer shape corresponding to the front surface of the transparent member in plan view, and having at least any one of recess parts formed on four side parts and R-shaped parts formed at four corner parts in the outer shape in plan view is used.
(10) The manufacturing method of a semiconductor device according to (8) above or (9) above,
   in which, as the protective material, a material having a base material formed by a predetermined material and an adhesive layer for pasting the base material to the transparent member is used.
(11) The manufacturing method of a semiconductor device according to (8) above,
   in which the transparent member has a rectangular plate-like outer shape with one plate surface as the front surface,
   as the protective material, a material having a substantially rectangular outer shape corresponding to the front surface of the transparent member in plan view, having recess parts formed on four side parts in the outer shape in plan view, and having a base material formed by a predetermined material and an adhesive layer for pasting the base material to the transparent member is used, and
   a recess amount of each of the recess parts with respect to a virtual straight line along a rectangular shape in the outer shape in plan view is 0.7 to 1.3 times a thickness of the adhesive layer.
(12) The manufacturing method of a semiconductor device according to (10) above or (11) above,
   in which the predetermined material for forming the base material includes PET, and
   the adhesive layer is formed by use of an acrylic resin adhesive.
(13) The manufacturing method of a semiconductor device according to any one of (7) to (12) above,
   in which, in the step of forming the sealing resin part, a resin material in a liquid state at normal temperature is used as a resin material for forming the sealing resin part.

### [Reference Signs List]

1: Imaging device (semiconductor device)
2: Substrate
3: Image sensor (semiconductor element)
4: Glass (transparent member)
4a: Front surface
5: Sealing resin part
5Y: Liquid resin
6: Support part
20: Protrusion part
20a: Side part
21: Upper surface
25: Glass covering part (transparent member covering part)
40: Protective sheet (protective material)
41: Base material
42: Adhesive layer
45: Side part
46: Recess part
47: Corner part
48: R-shaped part
50: Mold
82: Sealing resin receiving part (protective material)
83: Outer surface
90: Mold
200: Camera device
201: Imaging device (semiconductor device)
D1: Recess amount
V1: Virtual outer shape
Vla: Virtual straight line

## Claims

1. A semiconductor device comprising:
a substrate;
a semiconductor element that is provided on the substrate;
a transparent member that is provided on the semiconductor element through a support part; and
a sealing resin part that is formed around the semiconductor element and the transparent member on the substrate,
wherein the sealing resin part has a protrusion part having an upper surface thereof perpendicular to a plate thickness direction of the substrate, the upper surface being positioned above a front surface of the transparent member in the plate thickness direction.

2. The semiconductor device according to claim 1,
wherein a dimension between the front surface of the transparent member and the upper surface of the protrusion part is 10 to 200 µm in the plate thickness direction.

3. The semiconductor device according to claim 1,
wherein the transparent member has a rectangular plate-like outer shape with one plate surface as the front surface,
the protrusion part is formed in a frame shape by four side parts along a rectangular outer shape of the transparent member in plan view, and
a width of each side part of the protrusion part is 100 µm or more.

4. The semiconductor device according to claim 1,
wherein the protrusion part has a transparent member covering part extending on the front surface of the transparent member so as to cover an edge part of the front surface of the transparent member.

5. The semiconductor device according to claim 1,
wherein a sealing resin receiving part that is provided at an edge part on the front surface of the transparent member and is in contact with the protrusion part on an outer side surface is provided.

6. An electronic apparatus comprising:
a semiconductor device including
a substrate,
a semiconductor element that is provided on the substrate,
a transparent member that is provided on the semiconductor element through a support part, and
a sealing resin part that is formed around the semiconductor element and the transparent member on the substrate,
wherein the sealing resin part has a protrusion part having an upper surface thereof perpendicular to a plate thickness direction of the substrate, the upper surface being positioned above a front surface of the transparent member in the plate thickness direction.

7. A manufacturing method of a semiconductor device, the method comprising:
a step of mounting a semiconductor element on a substrate;
a step of providing, on the semiconductor element through a support part, a transparent member with at least a peripheral edge part of a front surface covered with a protective material; and
a step of forming a sealing resin part around the semiconductor element and the transparent member on the substrate by use of a mold.

8. The manufacturing method of a semiconductor device according to claim 7,
wherein, as the protective material, a film-like member that wholly covers the front surface of the transparent member or partially covers the front surface except the peripheral edge part of the front surface is used, and
a step of removing the protective material is included after the step of forming the sealing resin part.

9. The manufacturing method of a semiconductor device according to claim 8,
wherein the transparent member has a rectangular plate-like outer shape with one plate surface as the front surface, and,
as the protective material, a material having a substantially rectangular outer shape corresponding to the front surface of the transparent member in plan view, and having at least any one of recess parts formed on four side parts and R-shaped parts formed at four corner parts in the outer shape in plan view is used.

10. The manufacturing method of a semiconductor device according to claim 8,
wherein, as the protective material, a material having a base material formed by a predetermined material and an adhesive layer for pasting the base material to the transparent member is used.

11. The manufacturing method of a semiconductor device according to claim 8,
wherein the transparent member has a rectangular plate-like outer shape with one plate surface as the front surface,
as the protective material, a material having a substantially rectangular outer shape corresponding to the front surface of the transparent member in plan view, having recess parts formed on four side parts in the outer shape in plan view, and having a base material formed by a predetermined material and an adhesive layer for pasting the base material to the transparent member is used, and
a recess amount of each of the recess parts with respect to a virtual straight line along a rectangular shape in the outer shape in plan view is 0.7 to 1.3 times a thickness of the adhesive layer.

12. The manufacturing method of a semiconductor device according to claim 10,
wherein the predetermined material for forming the base material includes PET, and
the adhesive layer is formed by use of an acrylic resin adhesive.

13. The manufacturing method of a semiconductor device according to claim 7,
wherein, in the step of forming the sealing resin part, a resin material in a liquid state at normal temperature is used as a resin material for forming the sealing resin part.
